(19) Europäisches Patentamt
European Patent Office
Office européen des brevets

(11) **EP 4 761 512 A2**

(12) **EUROPEAN PATENT APPLICATION**

(43) Date of publication:
**17.06.2026 Bulletin 2026/25**

(21) Application number: **25210019.3**

(22) Date of filing: **21.10.2025**

(51) International Patent Classification (IPC):
**H10D 84/01** (2026.01)    **H10D 84/83** (2025.01)
**H10D 89/10** (2025.01)    **H10D 84/85** (2025.01)
**H10D 30/00** (2025.01)

(52) Cooperative Patent Classification (CPC):
**H10D 84/83; H10D 84/0149; H10D 84/0151;**
**H10D 89/10;** H10D 30/501; H10D 84/014;
H10D 84/0144; H10D 84/83135; H10D 84/8314;
H10D 84/832; H10D 84/85

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: **11.12.2024 KR 20240184169**

(71) Applicant: **Samsung Electronics Co., Ltd.**
**Suwon-si, Gyeonggi-do 16677 (KR)**

(72) Inventors:
• **YUN, Seokyeon**
**16677 Suwon-si (KR)**
• **KIM, Donggyun**
**16677 Suwon-si (KR)**
• **KIM, Sutae**
**16677 Suwon-si (KR)**
• **KIM, Hyelim**
**16677 Suwon-si (KR)**
• **PARK, Daehoon**
**16677 Suwon-si (KR)**
• **HEO, Yunmi**
**16677 Suwon-si (KR)**

(74) Representative: **Marks & Clerk LLP**
**15 Fetter Lane**
**London EC4A 1BW (GB)**

(54) **MASK, INTEGRATED CIRCUIT, AND METHOD OF CONTROLLING THRESHOLD VOLTAGES OF THE INTEGRATED CIRCUIT BY USING THE MASK**

(57)  A method controls threshold voltages for a plurality of transistors of a device to be manufactured. The device to be manufactured includes a plurality of logic cell regions in which a logic cell is formed, an active cell region in which an active cell is formed, and a first dummy cell region adjacent to a first logic cell region of the plurality of logic cell regions and adjacent to the active cell region , the first dummy cell region including a break region electrically isolated from each of the plurality of logic cell regions, the logic cell having a first width in a first direction and the active cell having a second width smaller than the first width in the first direction, the first dummy cell region being adjacent to the active cell region in the first direction. The method includes placing a device under manufacture that is to be formed into the device to be manufactured in a process chamber, the device under manufacture having device regions that correspond to the regions of the device to be manufactured; performing a first doping process on the device under manufacture by using a first mask that includes an opening exposing the device region corresponding to the active cell, exposing the device region corresponding to the first dummy cell region, and exposing the device region corresponding to the first logic cell region; and performing a second doping process on the device under manufacture by using a second mask that includes an opening exposing the device region corresponding to the active cell, exposing the device region corresponding to the first dummy cell region, and covering the device region corresponding to the first logic cell region.

FIG. 2

## Description

BACKGROUND

Aspects of the inventive concept relate to a mask, an integrated circuit, and a method of controlling a threshold voltage of transistors in the integrated circuit using the mask, and more particularly, to a doping process of controlling threshold voltages of an integrated circuit and a mask used therein.

Integrated circuits may be designed based on standard cells. In detail, standard cells may be arranged based on data which defines an integrated circuit, and a layout of the integrated circuit may be generated by routing the arranged standard cells. Such standard cells are predesigned and are stored in a cell library.

As a manufacturing process is subdivided, the sizes of patterns in a standard cell may decrease, and moreover, the sizes of standard cells may be reduced. As the sizes of patterns in a standard cell and the sizes of standard cells are reduced, in a transistor configured with an active region and a gate structure where a threshold voltage is to be controlled, it is difficult to accurately control a threshold voltage of a corresponding transistor, and due to this, reliability is reduced, which may result from difficulties from performing a doping process of controlling a threshold voltage.

SUMMARY

Aspects of the inventive concept provide a mask which is used for controlling a threshold voltage of transistors of an integrated circuit, particularly in transistors (hereinafter referred to as target transistors) where a threshold voltage is to be specifically controlled. Aspects of the inventive concept provide a mask which may relatively accurately control the threshold voltage of the target transistor, an integrated circuit where the threshold voltage may be controlled by using the mask, and a method of controlling the threshold voltage of the integrated circuit by using the mask.

The objects of the inventive concept are not limited to the aforesaid, but other objects not described herein will be clearly understood by those of ordinary skill in the art from descriptions below.

A mask according to an embodiment includes a plurality of logic cell regions corresponding to a location where a plurality of respective logic cells of a semiconductor device to be manufactured are to be positioned; and switch cell regions, each disposed between adjacent logic cell regions of the plurality of logic cell regions, or the switch cell regions disposed to surround at least a first logic cell region of the plurality of logic cell regions. Each switch cell region corresponds to a location of the semiconductor device to be manufactured that is electrically isolated from each of the plurality of respective logic cells, and the mask comprises, when placed in a position above the semiconductor device to be manufactured, a first opening corresponding to a logic cell region selected from among the plurality of logic cell regions and a second opening in a first switch cell region of the switch cell regions.

An integrated circuit according to an embodiment includes a plurality of logic cell regions where a plurality of respective logic cells are formed; a first switch cell region disposed adjacent to a first logic cell region of the plurality of logic cell regions ; a plurality of power rails extending in a first horizontal direction, formed in the plurality of logic cell regions and the first switch cell region, and configured to be supplied with a source voltage; a plurality of first gate structures disposed apart from each other in the first horizontal direction in one logic cell region selected from among the plurality of logic cell regions and extending in a second horizontal direction intersecting with the first horizontal direction; and a plurality of second gate structures disposed apart from each other in the first horizontal direction in the switch cell region and extending in the second horizontal direction. The switch cell region comprises a break region electrically isolated from each of the plurality of logic cell regions, and the plurality of first gate structures and the plurality of second gate structures result in transistors controlled by the first gate structures having different threshold voltages from transistors controlled by the second gate structures.

According to an embodiment, a method controls threshold voltages for a plurality of transistors of a device to be manufactured. The device to be manufactured includes a plurality of logic cell regions in which a logic cell is formed, an active cell region in which an active cell is formed, and a first dummy cell region adjacent to a first logic cell region of the plurality of logic cell regions and adjacent to the active cell region , the first dummy cell region including a break region electrically isolated from each of the plurality of logic cell regions, the logic cell having a first width in a first direction and the active cell having a second width smaller than the first width in the first direction, the first dummy cell region being adjacent to the active cell region in the first direction. The method includes placing a device under manufacture that is to be formed into the device to be manufactured in a process chamber, the device under manufacture having device regions that correspond to the regions of the device to be manufactured; performing a first doping process on the device under manufacture by using a first mask that includes an opening exposing the device region corresponding to the active cell, exposing the device region corresponding to the first dummy cell region, and exposing the device region corresponding to the first logic cell region; and performing a second doping process on the device under manufacture by using a second mask that includes an opening exposing the device region corresponding to the active cell, exposing the device region corresponding to the first dummy cell region, and covering the device region corresponding to the first logic cell region.

At least some of the above and other features of the invention are set out in the claims.

BRIEF DESCRIPTION OF THE DRAWINGS

Embodiments will be more clearly understood from the following detailed description taken in conjunction with the accompanying drawings in which:

FIG. 1 is a diagram for describing an integrated circuit according to embodiments;
FIG. 2 is a diagram for describing a mask according to embodiments;
FIG. 3 is a diagram for describing an integrated circuit according to embodiments;
FIG. 4A is a cross-sectional view taken along line A1-A1 of FIG. 3;
FIG. 4B is a cross-sectional view taken along line A2-A2 of FIG. 3;
FIGS. 5 to 7 and 8 to 10 are diagrams for describing a mask used for controlling a threshold voltage of the integrated circuit illustrated in FIG. 3;
FIG. 11 is a diagram for describing an integrated circuit according to other embodiments;
FIG. 12 is a cross-sectional view taken along line B-B of FIG. 11;
FIGS. 13 to 15 are diagrams for describing a mask used for controlling a threshold voltage of the integrated circuit illustrated in FIG. 11;
FIG. 16 is a diagram for describing an integrated circuit according to other embodiments;
FIGS. 17 to 19 are diagrams for describing a mask used for controlling a threshold voltage of the integrated circuit illustrated in FIG. 16;
FIG. 20 is a diagram for describing an integrated circuit according to other embodiments;
FIGS. 21 to 23 are diagrams for describing a mask used for controlling a threshold voltage of the integrated circuit illustrated in FIG. 20;
FIG. 24 is a diagram for describing an integrated circuit according to other embodiments; and
FIGS. 25 to 27 are diagrams for describing a mask used for controlling a threshold voltage of the integrated circuit illustrated in FIG. 24.

DETAILED DESCRIPTION OF THE EMBODIMENTS

Hereinafter, embodiments will be described in detail with reference to the accompanying drawings. Like reference numerals refer to like elements in the drawings, and their repeated descriptions are omitted.
Herein, a horizontal direction may include a first horizontal direction (an X direction) and a second horizontal direction (a Y direction), which intersect each other. A direction intersecting the first horizontal direction (the X direction) and the second horizontal direction (the Y direction) may be referred to as a vertical direction (a Z direction). Herein, a vertical level may be referred to as a height level with respect to a vertical direction (a Z direction) of an arbitrary element.
An element relatively disposed in a +Z direction with respect to another element may be referred to as being disposed above the other element, and an element relatively disposed in a -Z direction with respect to another element may be referred to as being disposed under the other element. However, spatially relative terms, such as "beneath," "below," "lower," "above," "upper," "top," "bottom," "front," "rear," and the like, may be used herein for ease of description to describe positional relationships, such as illustrated in the figures, for example. It will be understood that the spatially relative terms encompass different orientations of the device in addition to the orientation depicted in the figures. The directions described herein are defined relative to the structure of the device, and do not necessarily limit the device to a particular orientation, in use. An area of an element may denote a size occupied by the element in a surface parallel to a horizontal surface (e.g. a surface defined by the first and second horizontal directions), and a width of the element may denote a length of the element in a direction perpendicular to a direction in which the element extends. Also, a case where elements are coupled or electrically connected to each other may be simply referred to as corresponding elements being connected to each other. In the drawings, for convenience of illustration, only some layers may be illustrated. A pattern including a conductive material like a pattern of a wiring layer may be referred to as a conductive pattern, or may be simply referred to as a pattern.
It will be understood that, although the terms first and/or primary, second and/or secondary, third and/or tertiary, etc. may be used herein to describe various elements, components, regions, layers and/or sections, these elements, components, regions, layers and/or sections should not be limited by these terms. Such terms may include, for example and without limitation, "first," "primary first," "secondary first," "second," "primary second," "secondary second," etc. Unless the context indicates otherwise, these terms are only used to distinguish one element, component, region, layer, or section from another element, component, region, layer or section, for example as a naming convention. Thus, a first and/or primary element, component, region, layer or section discussed below in one section of the specification could be termed a second and/or secondary element, component, region, layer or section in another section of the specification or in the claims without departing from the teachings of the present invention. In addition, in certain cases, even if a term is not described using first and/or primary, second and/or secondary, etc. in the specification, it may still be referred to as first and/or primary, second and/or secondary in a claim in order to distinguish different claimed elements from each other. As used herein, the singular forms "a", "an", and "the" are intended to include the plural forms as well, unless the context clearly indicates otherwise. Additionally, the description may be specific to a portion of the device and the described structure may be repeated in other portions of the device. For example, the described structure may be an individual element of an array of elements forming the device. Accordingly, where the structure of a single element of a plurality of elements has been described, this structure may equally apply to other elements of the plurality of elements.

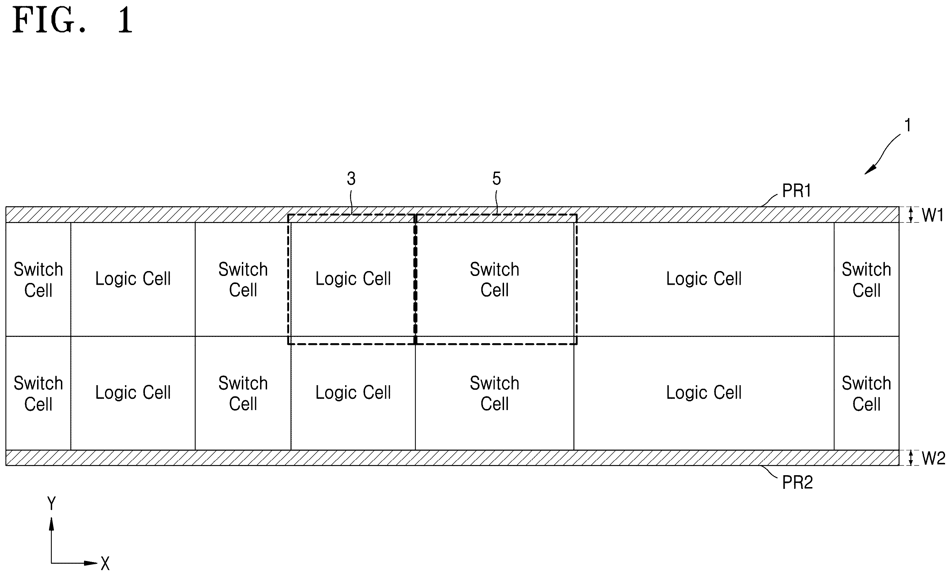

FIG. 1 is a diagram for describing an integrated circuit 1 according to embodiments.

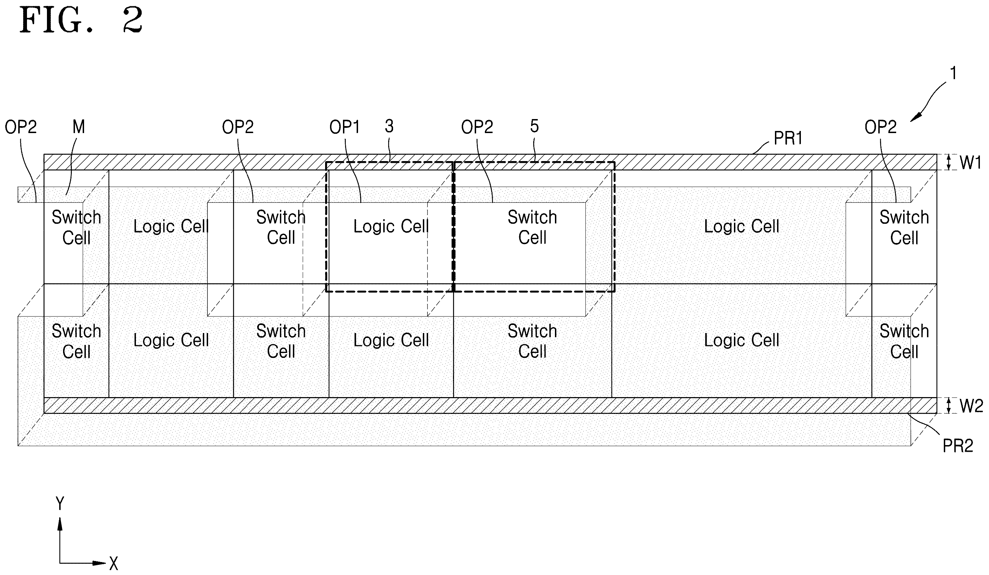

FIG. 2 is a diagram for describing a mask M according to embodiments. The mask may be, for example, a doping mask, corresponding to the integrated circuit 1, that allows doping of certain regions where the mask is open and prevents doping in other regions where the mask is closed. Throughout this application, a "device to be manufactured" refers to an end device formed using the mask. As such, during photolithography or other use of the mask, while the device is not yet complete, the device may be referred to as a "device under manufacture."

Referring to FIGS. 1 and 2, the integrated circuit 1 may include a logic cell region 3 where a logic cell is formed or is to be formed. The logic cell region 3 may include a plurality of logic cell regions. The integrated circuit 1 may also include a switch cell region 5 which is disposed between the plurality of logic cell regions 3 or surrounds the plurality of logic cell regions 3, where a switch cell is formed or is to be formed. The switch cell region 5 may include a plurality of switch cell regions. The switch cell region 5 may include a break region which is electrically isolated (e.g. insulated) from the logic cell region 3. More specifically, there may be a plurality of logic cell regions 3 for the device to be manufactured. For the device to be manufactured, each logic cell region 3 may be or comprise an integrated circuit that performs a logic function. There may be a plurality of switch cell regions 5 for the device to be manufactured. For the device to be manufactured, switch cell region 5 may include a switch cell pattern. In FIGS. 1 and 2, the logic cell regions are indicated with the label "logic cell," and the switch cell regions are indicated with the label "switch cell."

The logic cell regions 3 and switch cell regions 5, for both the device to be manufactured and the mask may be arranged in different manners. In one embodiment, the logic cell regions are alternatingly arranged with the switch cell regions. Each logic cell region may be adjacent to a switch cell region, and/or may be surrounded, at least in one direction (e.g., the X-direction) by switch cell regions. Similarly, each switch cell region may be adjacent to a logic cell region, and/or may be surrounded, at least in one direction (e.g., the X-direction) by logic cell regions.

A logic cell may include various semiconductor devices. In some embodiments, the logic cell may be a logic cell which is a unit for performing a certain function according to the purpose of the integrated circuit 1 in a memory region, an input/output (I/O) region, etc.

In some embodiments, a switch cell may be formed in the switch cell region 5. In some embodiments, the switch cell may be a cell for allowing a pattern density of a layout to be entirely uniform.

In embodiments, the switch cell may include a signal tap cell, a filler cell, and/or a finishing cell.

The signal tap cell may be a special cell which is used for complementing signal transfer and electrical characteristics and may be used to stabilize electrical characteristics (for example, voltage drop and current flow) and maintain signal integrity in a certain signal path. For instance, a signal tap cell may provide an electrical connection between two components (e.g., to improve signal transfer between the two components).

The filler cell may be an additional region which maintains a uniform process condition on a wafer or an entire substrate, and thus, helps the uniformity and function enhancement of integrated circuits. Alternatively, the filler cell may be a cell used for filling a space which is secured in an integrated circuit, for spacing between standard cells. Moreover, the filler cell may be electrically disconnected (i.e., insulated) from the logic cell, and thus, may be implemented not to directly affect functions of elements. Also, as an example, the filler cell may contribute to form a logic cell which is more uniform and is functionally enhanced, in a front end of line (FEOL) process. The filler cell may therefore include some or all of the components of an operational cell, but may not include connections to allow for transferring of signals or voltage between the operational cell and other cells. The filler cell may be a dummy cell.

The finishing cell may be a special cell which is disposed outside the plurality of logic cells and has a structure terminating gate electrodes or has a structure terminating active regions. For example, a portion of a gate electrode or active region may extend beyond a logic cell to end in a region where it is not connected to any other electrically-conductive component. A finishing cell may correspond to a portion of the device to be manufactured where this end region is formed.

In some other embodiments, the switch cell region 5 may include an active gate region where an active gate is formed and a dummy gate region where a dummy gate is formed.

As a design of integrated circuits advances highly and is thus complicated, much time and cost may be consumed in a layout design of the integrated circuit 1, and thus, a method which prepares a standard circuit and performs an automatic design by using cells thereof is being used. For example, one design method may use a standard cell. In a case which uses a method of designing a layout through a standard cell, elements such as a logic gate repeatedly used may be predefined as a standard cell and stored in a computer system, and then, may be placed at a desired position when designing a layout, thereby reducing the time consumed in a layout design. A standard cell may be previously registered in a computer through previous design and verification, and a logic design, placement, and routing may be performed by combining registered cells with computer aided design (CAD). For example, a standard cell may include one or more basic cells and/or one or more complex cells. For example, a basic cell may include a logic element such as an AND gate, an OR gate, a NOR gate, or an inverter. For example, a complex cell may be composed of a combination of two or more elements (e.g., two or more logic elements) selected from an AND gate, an OR gate, a NOR gate, and an inverter, such as an OAI (OR/AND/INVERTER) or an AOI (AND/OR/INVERTER). A standard cell may include storage elements such as a master-slave flip-flop and a latch.

Each standard cell may be constant in cell height (e.g., a height along a vertical axis when viewed in a plan view), and an integrated circuit may be designed by placing appropriate standard cells in a plurality of column forms. In detail, in a case of designing an integrated circuit, when normalized standard cells having a certain scale are previously stored in a library, a standard cell suitable for the purpose of a design may be unloaded from the library and may be placed as a plurality of cells on a chip, and optimal routing may be performed so that a routing length is shortest in a routing space between cells, thereby designing an entire circuit. For example, integrated circuits formed in the logic cell may be designed by a standard cell method.

In some embodiments, the switch cell may include dummy patterns having a pattern density and a shape, which are similar to patterns disposed in the logic cell. The dummy patterns may be formed around the logic cell and may not be electrically connected to internal circuits of the logic cell. Accordingly, the dummy patterns may not perform a direct electrical function on circuits. In detail, in the integrated circuit 1 according to an embodiment, as described above, active integrated circuits may be designed and placed in the logic cell based on the standard cell. Also, for example, the switch cell may include dummy patterns which are designed and placed based on the standard cell method, and the dummy patterns may have substantially the same shape and/or pattern density as those of patterns of the integrated circuit of the logic cell. However, a configuration of the switch cell is not limited thereto, and the dummy patterns may have a shape and/or a pattern density, which differ(s) from those of the patterns of the integrated circuit of the logic cell.

In FIGS. 1 and 2, it is illustrated that a plurality of logic cell regions 3 and a plurality of switch cell regions 5 are alternatingly arranged with respect to each other, but a structure of the integrated circuit 1 according to an embodiment is not limited thereto. For example, cells including a logic cell and a switch cell may be arranged in various structures and shapes based on an electric device which is to be implemented.

A first power rail PR1 and a second power rail PR2 may respectively be, for example, paths through which a source voltage and a reference voltage (for example, a ground voltage) are provided. As illustrated, the first and second power rails PR1 and PR2 may extend in parallel in a first horizontal direction (an X direction) and may be disposed apart from each other in a second horizontal direction (a Y direction). A width W1 of the first power rail PR1 in the second horizontal direction (the Y direction) perpendicular to the first horizontal direction (the X direction) may be set to be different from a width W2 of the second power rail PR2 in the second horizontal direction (the Y direction). For example, in order to complement voltage drop caused by an increase in resistance based on a reduction in power rail size, widths of power rails may increase, or a reinforcement pattern may be added to a filler cell, thereby substantially increasing an area of a path through which a current flows.

At least one cell may be disposed between the first and second power rails PR1 and PR2. As described above, each of the logic cells may be a cell which is supplied with a voltage from a power rail and performs a certain function in a device and may be based on the standard cell. For example, each of the logic cells may denote a logic element (for example, an AND gate, an OR gate, an XOR gate, an XNOR gate, an inverter, etc.) which performs a certain function. For example, each logic cell may include transistors for configuring a logic element and wirings which connect the transistors with each other.

In some embodiments, each of the switch cells may be disposed based on a circuit where the logic cells are designed, and then, may function as a dummy cell which fills an empty space between the logic cells. For example, the switch cells may not perform any signal-transmitting or operational function in a circuit.

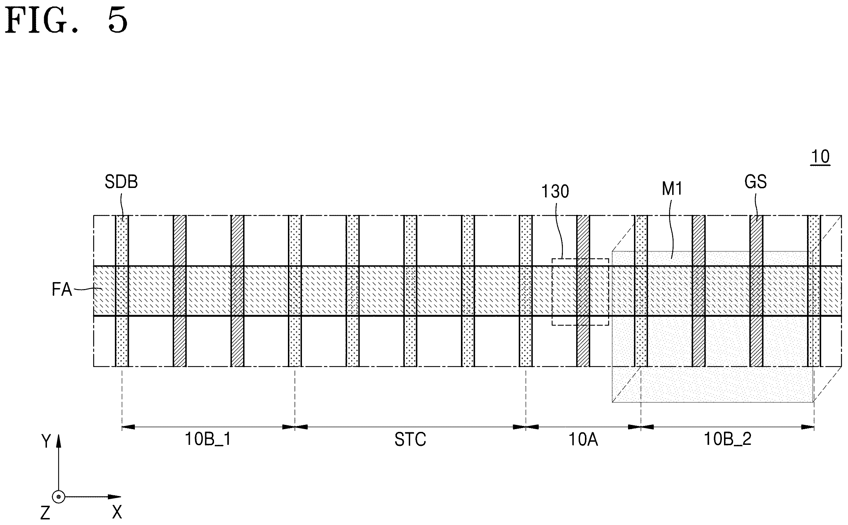

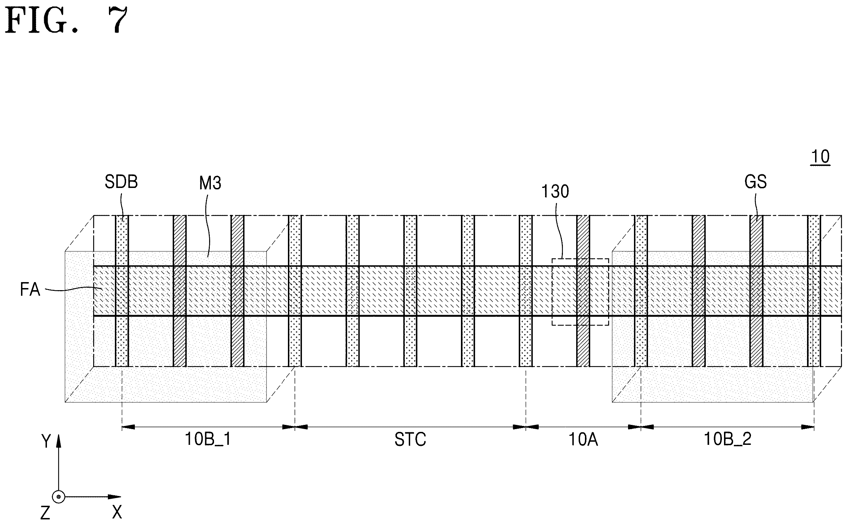

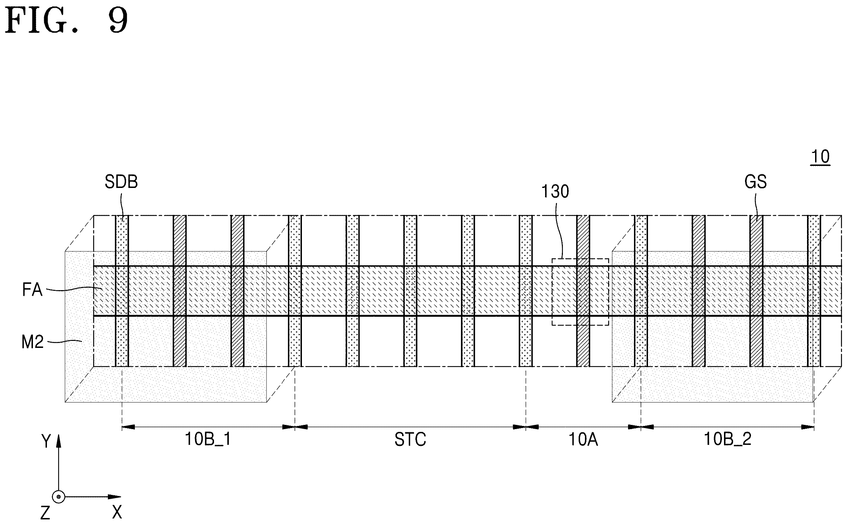

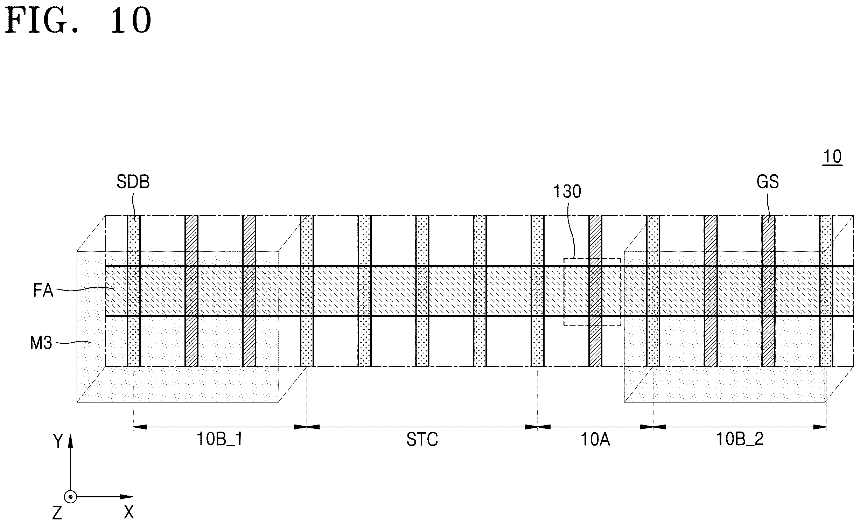

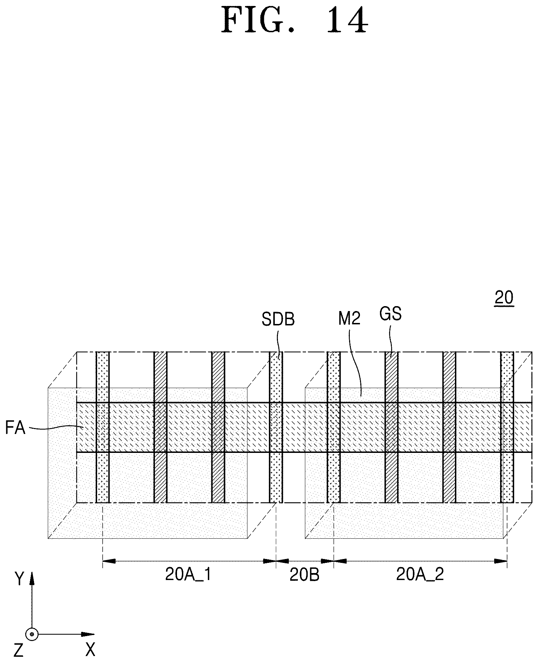

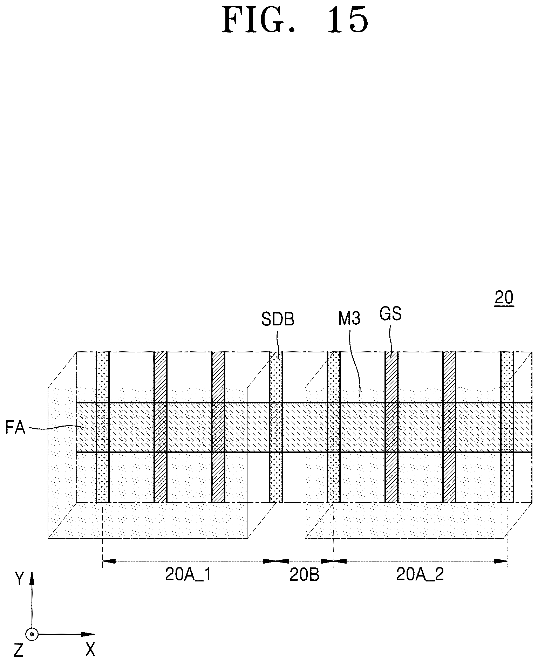

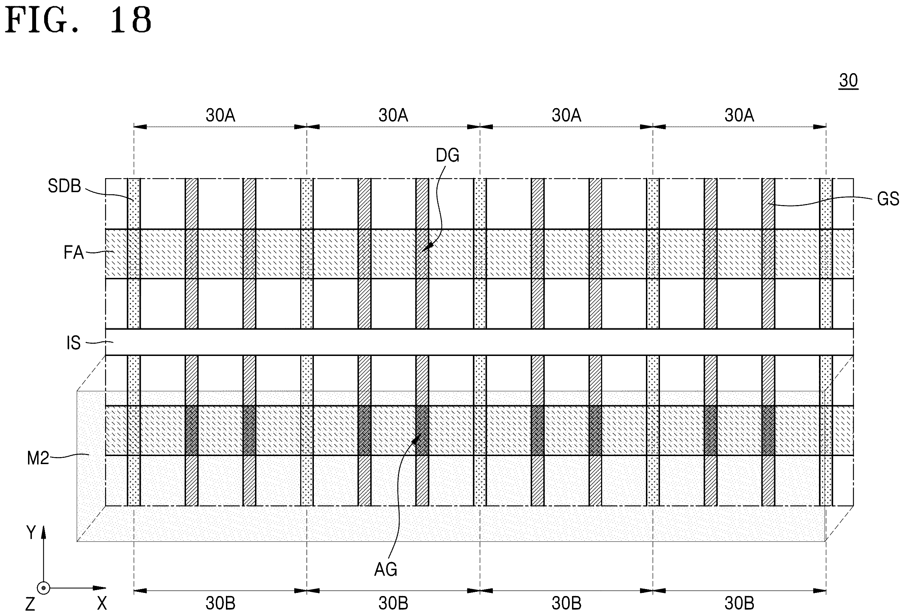

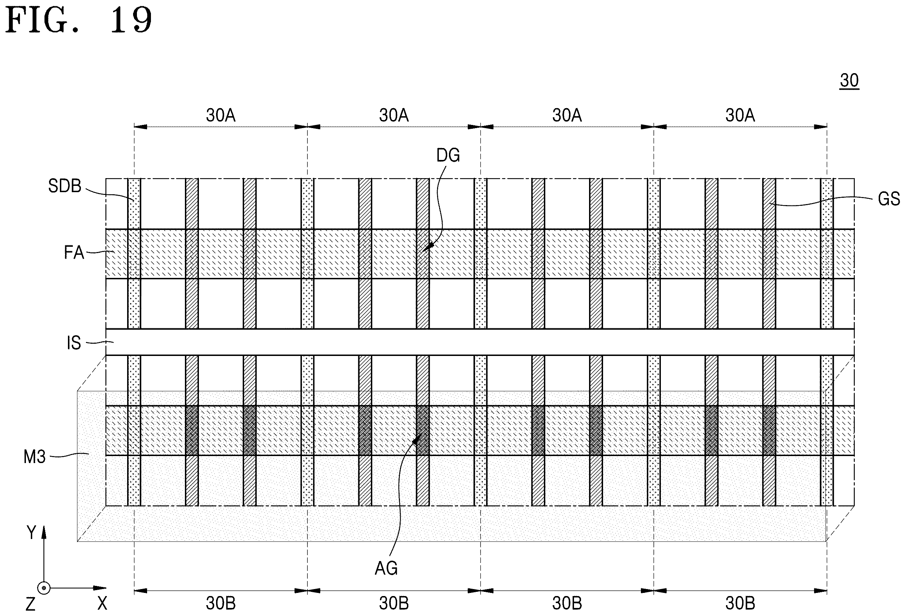

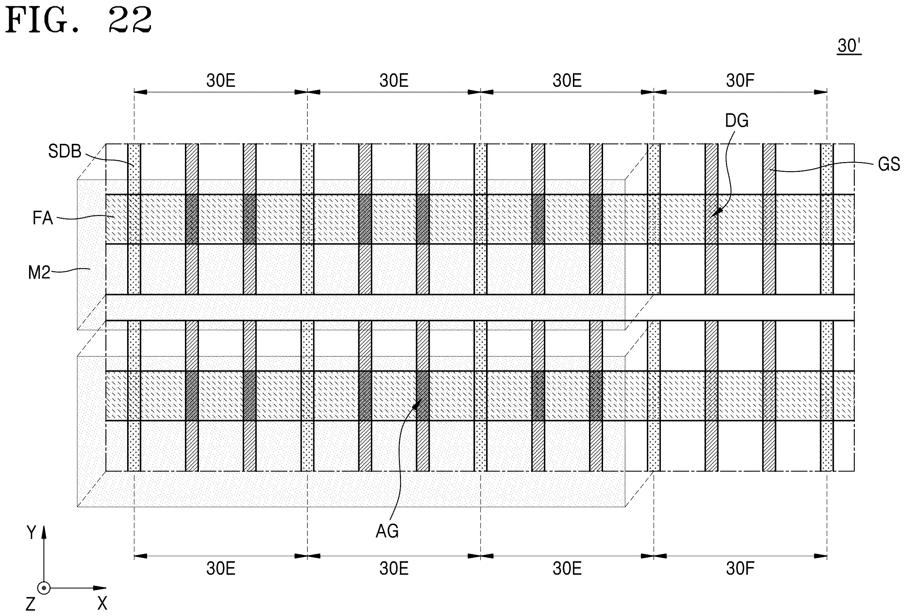

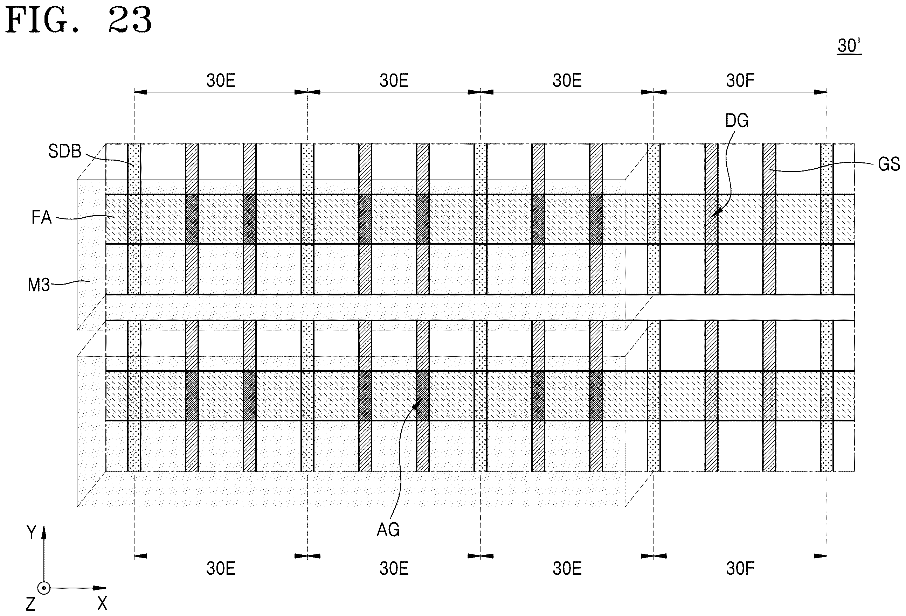

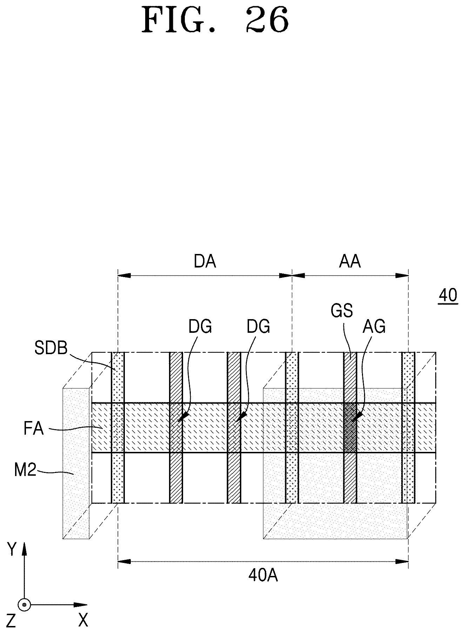

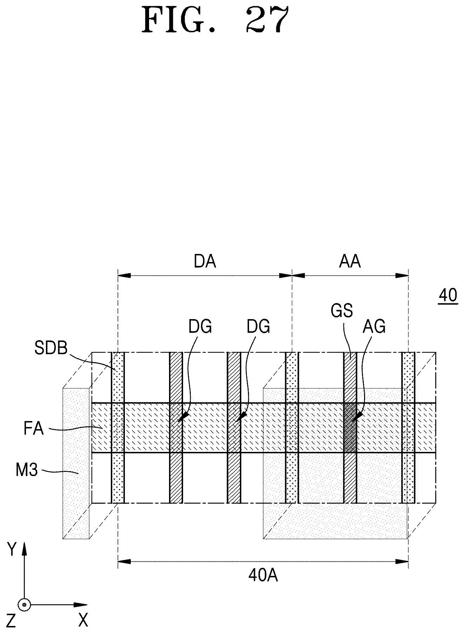

In some other embodiments, each of the switch cells may include an active gate which is activated to electrically configure a transistor, and moreover, may include a dummy gate which does not electrically configure a transistor on a periphery of the active gate. This may apply to the various switch cells described in FIGS. 5-27, such that one of the depicted dummy gates in the switch cells may be an active gate. An active gate may be a gate that is configured to pass an electrical signal to a transistor to enable the transistor to turn on and off. A dummy gate may be a gate that is not configured to pass an electrical signal to a transistor (e.g., that is not connected to be driven by an external signal source). The dummy gate may not be supplied with a voltage from the first and second power rails PR1 and PR2, and thus, may be defined as a deactivated gate. As such, part of a switch cell may include an active component, but because the active component is electrically cut off from a larger integrated circuit, the active components may not operate. Therefore, the switch cells are at least partly inoperable so that they are not configured to be used properly for logic functions. Switch cells may be dummy cells.

As illustrated in FIG. 2, the mask M according to embodiments may include a first opening OP1 and a second opening OP2. The first opening OP1 may be an opening in a region of the mask corresponding to a logic cell region 3 selected from among the plurality of logic cell regions 3 and exposes the selected logic cell region 3. The selected logic cell region 3 may include a target transistor where a threshold voltage is to be controlled. The first opening OP1 may expose the target transistor (or a relevant part of the target transistor such as a gate dielectric portion, gate portion, and/or semiconductor portion). The second opening OP2 may be an opening in a region of the mask corresponding to the switch cell region 5 and may expose a layer or component within the switch cell region 5. The first opening OP1 may at least have a width of 3 contacted poly pitch (CPP), and the second opening OP2 may at least have a width of 1 CPP. For example, the second opening OP2 may have a width of about 1 CPP to about 3 CPP. The width may refer to a width in a particular direction, such as the X direction.

For reference, a threshold voltage of a transistor may be calculated as expressed in the following Equation 1.

[Equation 1]

$$Vt = \varphi ms - (Qox + Qd)/Cox + 2\varphi f$$

Here, $\varphi ms$ may denote a work function potential difference of (e.g. between) a semiconductor configuring a channel and metal configuring a gate, $Qox$ may denote a fixed electric charge in a gate oxide surface, $Qd$ may denote a positive electric charge in an ion layer, $Cox$ may denote a capacitance per unit area of the gate, and $\varphi f$ may denote a potential difference between an intrinsic (or unique) Fermi level $Ei$ and a Fermi level $Ef$ of the semiconductor. $Vt$ may denote a threshold voltage. A work function potential difference may be a potential difference caused by a difference in work functions.

Based on Equation 1, the following methods may be performed for controlling a threshold voltage. A first method may be a method of controlling $\varphi ms$. A second method may be a method of controlling $Qox$. Also, a third method may be a method of controlling $\varphi f$.

For example, the first method may be implemented by doping ions on a semiconductor or applying metal having a corresponding work function. A work function of the semiconductor may increase or decrease by doping ions, and thus, a work function difference between the semiconductor and the metal may increase or decrease. Also, by using the metal having the corresponding work function, the work function difference between the semiconductor and the metal may increase or decrease.

The second method may be implemented by increasing or decreasing a value of $Qox$, and based on Equation 1, $Vth$ may decrease when a value of $Qox$ is reduced, and a threshold voltage may increase when a value of $Qox$ increases. Moreover, the second method may be expressed as $Qox = \varepsilon_0\varepsilon_R/tox$. Here, $\varepsilon_0$ may denote the vacuum permittivity, $\varepsilon_R$ may denote a dielectric constant (e.g. the relative permittivity) of a gate oxide film, and tox may denote a thickness of the gate oxide film, and thus, in a case which reduces $Qox$, a thickness of the gate oxide film may increase, or a material having a low dielectric constant may be used.

Also, the third method may be implemented by doping ions on a semiconductor. For example, in a case where a semiconductor layer includes a p-type substrate, $\varphi f$ may increase by doping arsenide (As).

According to embodiments, the first opening OP1 may be selectively formed or omitted, depending on a threshold voltage which is to be set in the selected logic cell region 3 and a condition of a doping process for controlling the threshold voltage. The second opening OP2 may be always formed (e.g., may be always used, for example, in all masks during a manufacturing process) for a doping process for controlling the threshold voltage of the selected logic cell region 3, and as the second opening OP2 is always formed, the accuracy of a doping process performed through the first opening OP1 may be relatively enhanced. Examples of this enhancement are described in more detail below in connection with FIGS. 5-7, for example.

Hereinafter, the switch cell region 5 and the mask M will be described in more detail.

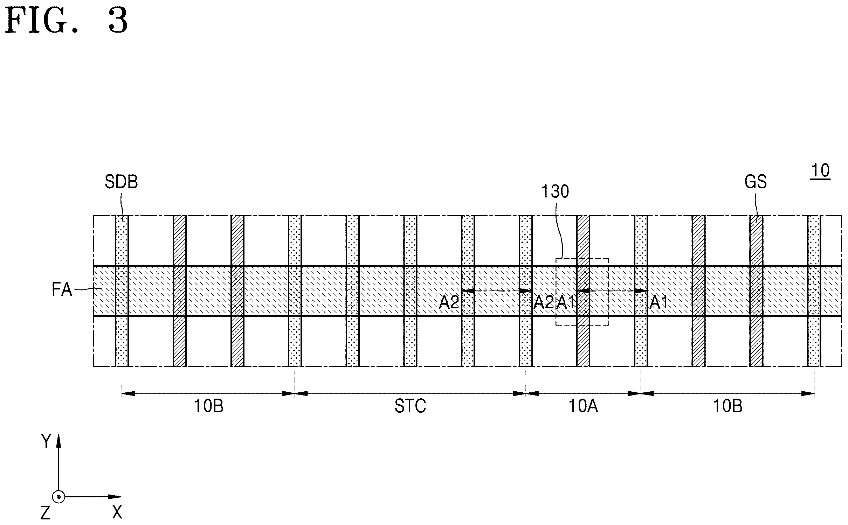

FIG. 3 is a diagram for describing an integrated circuit 10 according to embodiments.

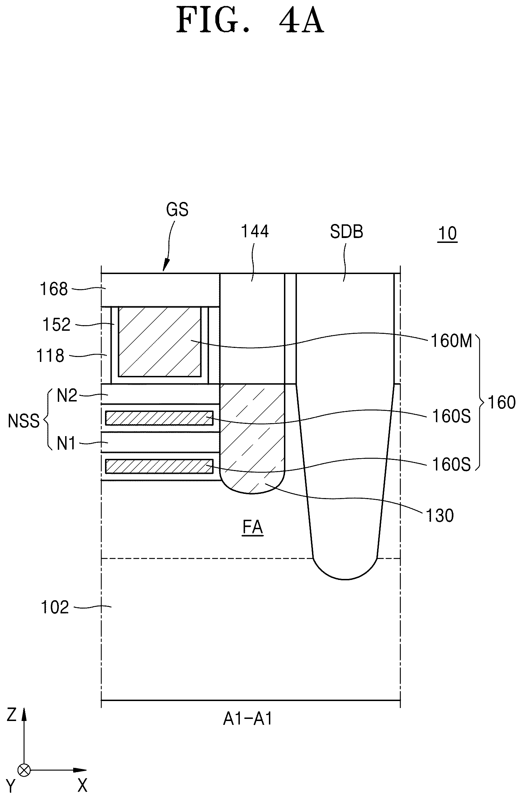

FIG. 4A is a cross-sectional view taken along line A1-A1 of FIG. 3.

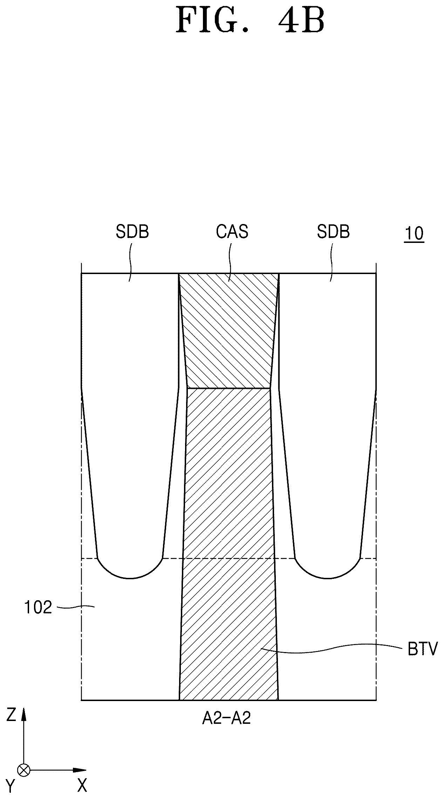

FIG. 4B is a cross-sectional view taken along line A2-A2 of FIG. 3.

The integrated circuit 10 may include an adjacent cell 10A, a standard cell 10B, and a signal tap cell STC. The adjacent cell 10A may be disposed between the signal tap cell STC and the standard cell 10B. The adjacent cell 10A may be a cell which is disposed on a periphery of the signal tap cell STC. The standard cell 10B may be a logic cell. The adjacent cell 10A may be an active cell such as a logic cell or a single-transistor cell.

Also, the integrated circuit 10 may include a plurality of gate structures GS which are disposed apart from each other in a first horizontal direction (an X direction) and extend in a second horizontal direction (a Y direction) and a plurality of single diffusion breaks SDB which are disposed apart from each other in the first horizontal direction (the X direction) and extend in the second horizontal direction (the Y direction). The plurality of single diffusion breaks SDB or one single diffusion break SDB may be disposed between consecutive gate structures of the plurality of gate structures GS. For instance, one or more single diffusion breaks SDV may be disposed between consecutive gate structures of the plurality of gate structures GS. Items disposed between the single diffusion breaks may be isolated from circuitry in cell regions, and therefore, a region corresponding to an area between two single diffusion breaks may be described as a break region.

The adjacent cell 10A, the standard cell 10B, and the signal tap cell STC may be formed on a substrate 102.

The substrate 102 may be a silicon substrate or a silicon-on-insulator (SOI). On the other hand, the substrate 102 may include silicon germanium, a silicon germanium on insulator (SGOI), indium antimonide, a lead tellurium compound, indium arsenic, indium phosphide, gallium arsenic, or gallium antimonide, but is not limited thereto.

The integrated circuit 10 may include a field effect transistor (FET) having a gate-all-around (GAA) structure which includes an active region FA having a nano-sheet shape and a gate surrounding the active region FA. For example, the integrated circuit 10 may include a multi-bridge channel FET (MBCFET). However, the inventive concept is not limited thereto, and the integrated circuit 10 may include a planar FET and a fin FET.

The active region FA may be disposed to extend in the first horizontal direction (the X direction). In some embodiments, the active region FA may be a region where a p-type transistor is formed and may include a well region doped with n-type impurities. In some other embodiments, the active region FA may be a region where an n-type transistor is formed, and for example, may include a well region doped with p-type impurities. The active region FA may be a region which is defined by a deep trench of the substrate 102. For example, a region, except the active region FA, of the substrate 102 may be a region where the deep trench is formed.

Each of a plurality of nanosheet stacks NSS may include a first nanosheet N1 and a second nanosheet N2, which overlap each other in a vertical direction (a Z direction) on the active region FA. Each of a plurality of gate lines 160 may surround the first nanosheet N1 and the second nanosheet N2, which overlap each other in the vertical direction (the Z direction) and are included in the nanosheet stack NSS.

The term "nanosheet" used herein may denote a conductive structure including a cross-sectional surface substantially perpendicular to a direction in which a current flows. A nanosheet may have a thickness in the range of 1 to 100 nm. The nanosheet may be understood as including a nanowire. A nanowire may have a thickness in the range of 1 to 100 nm and may have a width in the range of 1 to 100 nm.

The first nanosheet N1 and the second nanosheet N2 each included in the nanosheet stack NSS may function as a channel region. In embodiments, each of the first nanosheet N1 and the second nanosheet N2 may have a thickness selected from a range of about 4 nm to about 6 nm, but is not limited thereto. Here, a thickness of each of the first nanosheet N1 and the second nanosheet N2 may denote a size thereof in the vertical direction (the Z direction). In embodiments, the first nanosheet N1 and the second nanosheet N2 may have substantially the same thickness in the vertical direction (the Z direction). In other embodiments, at least partial portions of the first nanosheet N1 and the second nanosheet N2 may have different thicknesses in the vertical direction (the Z direction). In embodiments, the first nanosheet N1 and the second nanosheet N2 each included in the nanosheet stack NSS may include a silicon (Si) layer, a silicon germanium (SiGe) layer, or a combination thereof.

The first nanosheet N1 and the second nanosheet N2 each included in one nanosheet stack NSS may have the same or similar sizes (e.g., widths) in the first horizontal direction (the X direction). In other embodiments, unlike the illustration of FIG. 4A, at least partial portions of the first nanosheet N1 and the second nanosheet N2 each included in one nanosheet stack NSS may have different sizes (e.g., widths) in the first horizontal direction (the X direction). In an embodiment, a case where each of a plurality of nanosheet stacks NSS includes two nanosheets is described, but the inventive concept is not limited thereto. For example, the nanosheet stack NSS may include at least one nanosheet, and the number of nanosheets configuring the nanosheet stack NSS is not limited to one or to two.

Each of the plurality of gate lines 160, also described as gate electrodes, may include a main gate portion 160M and a plurality of sub gate portions 160S. The main gate portion 160M may cover an upper surface of the nanosheet stack NSS and may extend lengthwise in the second horizontal direction (the Y direction). The plurality of sub gate portions 160S may be provided as one body with the main gate portion 160M and may be disposed one-by-one between the first nanosheet N1 and the second nanosheet N2 and between the first nanosheet N1 and the active region FA. With respect to the vertical direction (the Z direction), a thickness of each of the plurality of sub gate portions 160S may be less than that of the main gate portion 160M.

Each of the plurality of gate lines 160 may include or be formed of metal, metal nitride, metal carbide, or a combination of one or more thereof. The metal may be selected from among titanium (Ti), tungsten (W), ruthenium (Ru), niobium (Nb), molybdenum (Mo), hafnium (Hf), nickel (Ni), cobalt (Co), platinum (Pt), ytterbium (Yb), terbium (Tb), dysprosium (Dy), erbium (Er), and palladium (Pd). The metal nitride may be selected from among titanium nitride (TiN) and tantalum nitride (TaN). The metal carbide may be titanium aluminum carbide (TiAlC). However, a material configuring the plurality of gate lines 160 is not limited to the above description.

A gate dielectric layer 152 may be disposed between the nanosheet stack NSS and the gate line 160. In embodiments, the gate dielectric layer 152 may be configured in a stack structure of an interface dielectric layer and a high-k dielectric layer. The interface dielectric layer may include a low-k dielectric material layer having a dielectric constant of about 9 or less, and for example, may include silicon oxide, silicon oxynitride, or a combination thereof. In embodiments, the interface dielectric layer may be omitted. The high-k dielectric layer may include a material which has a dielectric constant that is greater than that of silicon oxide. For example, the high-k dielectric layer may have a dielectric constant of about 10 to about 25. The high-k dielectric layer may include hafnium oxide, but is not limited thereto.

Herein, the gate dielectric layer 152 and the gate line 160 may form a "gate structure GS". According to embodiments, each of the gate dielectric layer 152 and the gate line 160 may include a portion which overlaps the plurality of nanosheet stacks NSS.

According to embodiments, a plurality of transistors may be formed in portions where the plurality of nanosheet stacks NSS, the gate dielectric layer 152, and the gate line 160 overlap each other. The plurality of transistors may each be a nanosheet transistor. According to embodiments, the plurality of transistors may include a PMOS transistor and an NMOS transistor. For example, each of the plurality of transistors may include at least one nanosheet stack NSS, the gate dielectric layer 152 and the gate line 160 each surrounding the at least one nanosheet stack NSS, and a plurality of source/drain regions 130 facing the at least one nanosheet stack NSS in the first horizontal direction (the X direction).

Each of the plurality of source/drain regions 130 may be disposed between two adjacent gate lines 160 of the plurality of gate lines 160. Each of the plurality of source/drain regions 130 may be disposed at a position adjacent to at least one gate line 160 selected from among the plurality of gate lines 160. Each of the plurality of source/drain regions 130 may include surfaces facing the first nanosheet N1 and the second nanosheet N2 each included in an adjacent nanosheet stack NSS.

A capping insulation pattern 168 may be disposed on the gate dielectric layer 152 and the gate line 160. In detail, the capping insulation pattern 168 may cover an upper surface of the main gate portion 160M and an upper surface of a portion, surrounding the main gate portion 160M, of the gate dielectric layer 152. The capping insulation pattern 168 may include silicon nitride or silicon oxide.

Both (e.g., opposite) sidewalls of each of the gate line 160 and the capping insulation pattern 168 may be covered by an outer insulation spacer 118. In detail, the outer insulation space 118 may cover both (e.g., opposite) sidewalls of the main gate portion 160M, on an upper surface of each of the plurality of nanosheet stacks NSS. The outer insulation spacer 118 may be apart from the gate line 160 with the gate dielectric layer 152 therebetween.

An upper surface of each of the plurality of source/drain regions 130, a sidewall of each of the plurality of outer insulation spacers 118, and a sidewall of the capping insulation pattern 168 may be covered by an inter-gate insulation layer 144. The inter-gate insulation layer 144 may be or include silicon oxide, but is not limited thereto.

The single diffusion break SDB may be disposed on the substrate 102. The single diffusion break SDB may divide the active region FA into a plurality of regions. The single diffusion break SDB may be an insulating barrier that divides (e.g. separates) the active region FA into two regions. The single diffusion break SDB may extend into the substrate 102. Considering a manufacturing process of forming the single diffusion break SDB, at least a portion of the active region FA may be removed, and then, an insulating material may be filled in a portion from which the active region FA has been removed. Accordingly, the single diffusion break SDB may be formed. Therefore, a portion of a sidewall of the single diffusion break SDB may contact the active region FA. The single diffusion break SDB may include or be formed of, for example, an insulating material, and may be described generally as an insulating layer or an isolation layer. The single diffusion break SDB is illustrated as a single layer, but is not limited thereto.

Each of a plurality of gate structures GS and a corresponding single diffusion break SDB of a plurality of single diffusion breaks SDB may be disposed adjacent to each other in the first horizontal direction (the X direction). Each of a plurality of gate structures GS and a corresponding single diffusion break SDB of a plurality of single diffusion breaks SDB may be apart (e.g., spaced apart) from each other by about 1 CPP in the first horizontal direction (the X direction). For example, the plurality of gate structures GS may be apart from each other by about 1 CPP. As another example, a gate structure GS and a single diffusion break SDB adjacent to each other may be apart from each other by about 1 CPP. As another example, a plurality of single diffusion breaks SDB adjacent to each other may be apart from each other by about 1 CPP. While the term "contacted poly pitch" is used, this need not imply any particular material of the gate structure GS. More generally, the term "contacted poly pitch" may refer to the pitch of the gate structures GS.

For example, in a case in which it is assumed that there are a first gate structure and a second gate structure adjacent to each other, when a distance in the first horizontal direction (the X direction) between a center line of a first gate structure extending in the second horizontal direction (the Y direction) and a center line of a second gate structure extending in the second horizontal direction (the Y direction) is about 1 CPP, this may denote that another gate structure or a single diffusion break is not disposed between the first gate structure and the second gate structure. As such, 1 CPP may refer to a distance between adjacent gate structures in a semiconductor device. In addition, where gate structures and single diffusion breaks are arranged in a regular manner to have a constant pitch, 1 CPP may refer to a distance or pitch between adjacent structures among these gate structures and single diffusion breaks, and may refer in general to a pitch in a first direction between repeated, equally spaced-apart line patterns extending in a second direction perpendicular to the first direction.

At least a portion of the single diffusion break SDB may be disposed at a boundary of the standard cell 10B extending in the second horizontal direction (the Y direction) and may isolate adjacent standard cells 10B from each other. The single diffusion break SDB may be disposed in the standard cell 10B as well as the boundary of the standard cell 10B. Hereinafter, however, a case where the single diffusion break SDB is disposed at the boundary of the standard cell 10B extending in the second horizontal direction (the Y direction) will be described.

As illustrated in FIG. 4B, the signal tap cell STC may include at least two single diffusion breaks SDB adjacent to each other in the first horizontal direction (the X direction). For example, the at least two single diffusion breaks SDB may include a first single diffusion break SDB and a second single diffusion break SDB. A backside through via BTV may pass through a region between the first single diffusion break SDB and the second single diffusion break SDB. The backside through via BTV may be electrically connected to a contact CAS and may be electrically connected to a wiring line (not shown) configured on a front-side surface of the substrate 102, and for example, may be electrically connected to a signal line (not shown). The backside through via BTV and the signal line (not shown) may perform a function of a signal distribution network.

In some embodiments, the first and second power rails PR1 and PR2 (see FIGS. 1 and 2) of FIGS. 1 and 2 may be configured on a backside surface of the substrate 102, and a signal line (not shown) and a power rail (not shown) may be respectively configured on the front-side surface and the backside surface of the substrate 102, and thus, a degree of placement freedom of a pattern may be implemented to be relatively high. However, the inventive concept is not limited thereto.

In embodiments, the standard cell 10B may at least have a width of 3 CPP, and the standard cell 10A may at least have a width of 1 CPP or 2 CPP which is less than 3 CPP.

FIGS. 5 to 7 and 8 to 10 are diagrams for describing a mask used for controlling a threshold voltage of the integrated circuit 10 illustrated in FIG. 3, as well as a method of manufacturing an integrated circuit device.

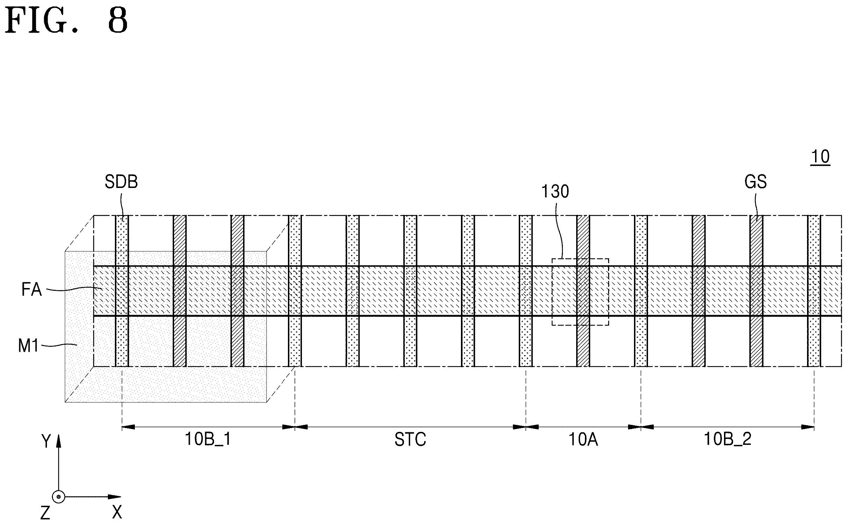

In detail, FIGS. 5 to 7 are diagrams for describing a mask used for controlling a threshold voltage of a first standard cell 10B_1, and FIGS. 8 to 10 are diagrams for describing a mask used for controlling a threshold voltage of a second standard cell 10B_2. FIGS. 5 to 7 and 8 to 10 are diagrams for describing a mask used for controlling a threshold voltage, and in addition to the mask illustrated in FIGS. 5 to 7 and 8 to 10, a mask based on various shapes and combinations may be adopted within the technical scope of the inventive concept.

Referring to FIGS. 5 to 7, initially, a device under manufacture having regions that correspond to the integrated circuit device of Figs. 1, 3, 4A, and/or 4B is placed in a process chamber. A first mask M1 may include an opening which opens (e.g., exposes) an adjacent cell 10A, a first standard cell 10B_1, and a signal tap cell STC and closes (e.g., covers) a second standard cell 10B_2, of the device under manufacture, and each of a second mask M2 and a third mask M3 may include an opening which opens (e.g., exposes) the adjacent cell 10A and the signal tap cell STC and closes (e.g., covers) the first standard cell 10B_1 and the second standard cell 10B_2 of a device under manufacture. The openings may expose one or more components in each cell region corresponding to a cell.

To control a threshold voltage (e.g., a first threshold voltage) of a first standard cell 10B_1, a first doping process in a state in which the first mask M1 is disposed, a second doping process in a state in which the second mask M2 is disposed, and a third doping process in a state in which the third mask M3 is disposed may be sequentially performed. The first to third doping processes may be performed under different process conditions. For example, the amounts of dopants may differ for each process.

According to some embodiments, in order to achieve a desired threshold voltage, a cell may need to have a particular mask opening size. For example, to achieve a first threshold voltage, a minimum width of a mask opening for a manufacturing process such as ion implantation may need to be about 3 CPP. In some embodiments, the adjacent cell 10A may not satisfy the width of 3 CPP. For instance, the adjacent cell 10A may have a width of about 1 CPP to about 2 CPP. Nevertheless, the adjacent cell 10A may still achieve the first threshold voltage, because the masks M1 to M3 may be designed such that they expose both the adjacent cell 10A and the signal tap cell STC together.

Referring to FIGS. 8 to 10, a first mask M1 may include an opening which opens (e.g., exposes) an adjacent cell 10A, a second standard cell 10B_2, and a signal tap cell STC and closes (e.g., covers) a first standard cell 10B_1 of a device under manufacture, and each of a second mask M2 and a third mask M3 may include an opening which opens (e.g., exposes) the adjacent cell 10A and the signal tap cell STC and closes (e.g., covers) the first standard cell 10B_1 and the second standard cell 10B_2 of a device under manufacture.

To control a threshold voltage (e.g., a second threshold voltage) of a second standard cell 10B_2, a first doping process in a state in which the first mask M1 is disposed, a second doping process in a state in which the second mask M2 is disposed, and a third doping process in a state in which the third mask M3 is disposed may be sequentially performed. The first to third doping processes may be performed under different process conditions. For example, the amounts of dopants may differ for each process. Also, the first to third doping processes may have process conditions which differ from those of the doping processes described above with reference to FIGS. 5 to 7. Accordingly, the adjacent cell 10A may have a second threshold voltage which differs from the first threshold voltage.

Similar to the description above with respect to FIGS. 5 to 7, according to some embodiments, in order to achieve a desired threshold voltage, a cell may need to have a particular mask opening size. For example, to achieve a second threshold voltage, a minimum width of a mask opening for a manufacturing process such as ion implantation may need to be about 3 CPP. In some embodiments, the adjacent cell 10A may not satisfy the width of 3 CPP. For instance, the adjacent cell 10A may have a width of about 1 CPP to about 2 CPP. Nevertheless, the adjacent cell 10A may still achieve the second threshold voltage, because the masks M1 to M3 may be designed such that they expose both the adjacent cell 10A and the signal tap cell STC together. It can be presumed that, since the adjacent cell 10A has a plurality of different threshold voltages (e.g., the first threshold voltage and the second threshold voltage), the signal tap cell STC also may have a plurality of different threshold voltages (e.g., the first threshold voltage and the second threshold voltage). Accordingly, it can be presumed that the signal tap cell STC may be exposed in an opening of a mask which is used in a doping process for controlling threshold voltages of different standard cells.

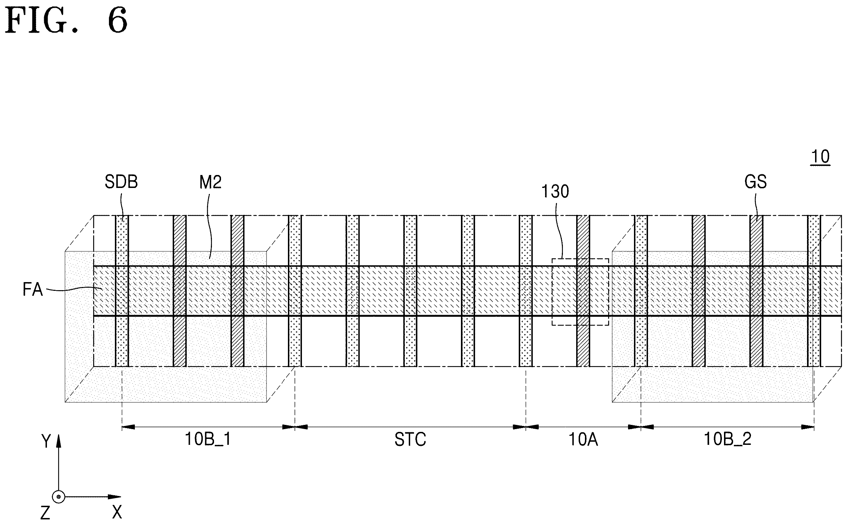

As can be seen from FIGS. 5-7 and 8 to 10, a method is described for controlling threshold voltages for a plurality of transistors of a device to be manufactured. The device to be manufactured may include a plurality of logic cell regions in which a logic cell is formed, an active cell region in which an active cell is formed, and a first dummy cell region adjacent to a first logic cell region of the plurality of logic cell regions and adjacent to the active cell region. The first dummy cell region may include a break region electrically isolated from each of the plurality of logic cell regions. The logic cell may have a first width in a first direction and the active cell may have a second width smaller than the first width in the first direction, wherein the first dummy cell region is adjacent to the active cell region in the first direction. The method may include placing a device under manufacture that is to be formed into the device to be manufactured in a process chamber, the device under manufacture having device regions that correspond to the regions of the device to be manufactured; performing a first doping process on the device under manufacture by using a first mask (e.g., mask M1 depicted in FIG. 5) that includes an opening exposing the device region corresponding to the active cell, exposing the device region corresponding to the first dummy cell region, and exposing the device region corresponding to the first logic cell region. The method may further include performing a second doping process on the device under manufacture by using a second mask (e.g., mask M2 depicted in FIG. 6) that includes an opening exposing the device region corresponding to the active cell, exposing the device region corresponding to the first dummy cell region, and covering the device region corresponding to the first logic cell region.

As can be seen in the example of FIGS. 3, 4A, 4B, and 5-7, a width of the active cell region (e.g., 10A) in the first direction (e.g., X direction) is smaller than a width of the first logic cell region (e.g., 10B_1) in the first direction. Also, a combined width of the active cell region (e.g., 10A) and the adjacent dummy cell region (e.g., STC) in the first direction (e.g., X direction) is larger than a width of the first logic cell region (e.g., 10B_1) in the first direction.

According to some embodiments, the first logic cell region (e.g., 10B_1), the dummy cell region (e.g., STC), and the active cell region (e.g., 10A) are arranged along the first direction; throughout a combined region including the first logic cell region, the dummy cell region, and the active cell region, a plurality of extended patterns, which may be for example line patterns (e.g., conductive lines such as gate structures GS, and diffusion breaks SDB) are formed to extend in a second direction (e.g., Y direction) perpendicular to the first direction, and are spaced apart from each other according to a constant pitch in the first direction; and the width in the first direction of the active cell region is equal to or smaller than two times the pitch. As a result of the first and second doping processes with the different masks, a threshold voltage of a transistor in the active region may be different from a threshold voltage of a transistor in the first logic cell region.

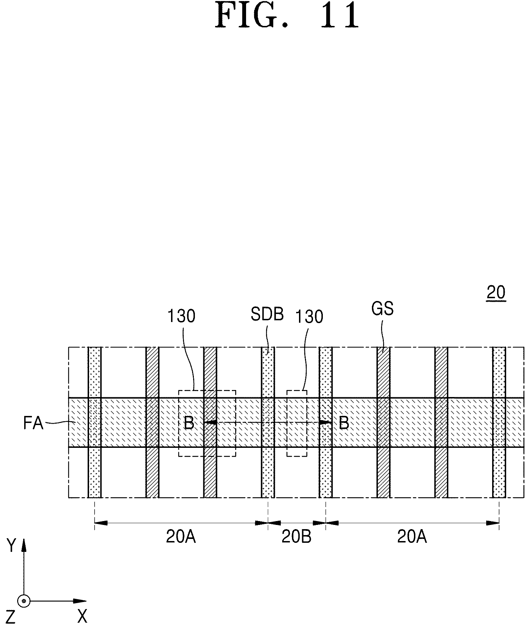

FIG. 11 is a diagram for describing an integrated circuit 20 according to other embodiments.

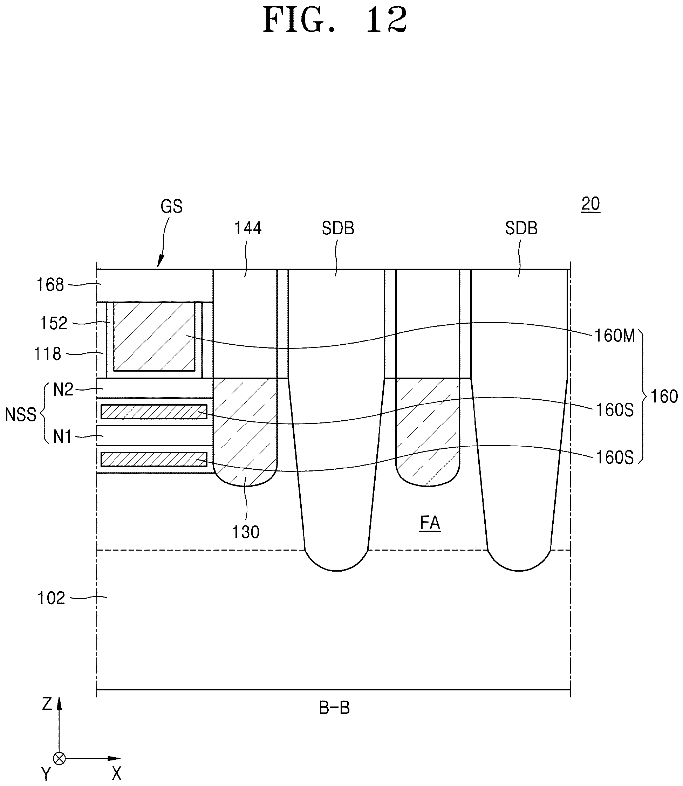

FIG. 12 is a cross-sectional view taken along line B-B of FIG. 11.

The integrated circuit 20 may be configured to be similar to the integrated circuit 10 described above with reference to FIGS. 3, 4A, and 4B, and thus, a difference therebetween will be mainly described below.

Referring to FIGS. 11 and 12, the integrated circuit 20 may include a standard cell 20A and a filler cell 20B. The filler cell 20B may be disposed between a plurality of standard cells 20A.

Also, the integrated circuit 20 may include a plurality of gate structures GS which are disposed apart from each other in a first horizontal direction (an X direction) and extend in a second horizontal direction (a Y direction) and a plurality of single diffusion breaks SDB which are disposed apart from each other in the first horizontal direction (the X direction) and extend in the second horizontal direction (the Y direction). A plurality of single diffusion breaks SDB may be disposed between the plurality of gate structures GS.

The plurality of single diffusion breaks SDB may be disposed at a boundary between the filler cell 20B and the standard cell 20A extending in the second horizontal direction (the Y direction) and may isolate the standard cell 20A from the filler cell 20B.

As illustrated in FIG. 12, the filler cell 20B may include at least two single diffusion breaks SDB adjacent to each other in the first horizontal direction (the X direction). A source/drain region 130 and an inter-gate insulation layer 144 covering the source/drain region 130 may be provided between two adjacent single diffusion breaks SDB. The filler cell 20B illustrated in FIG. 12 may include dummy patterns (e.g., dummy source/drain regions, etc.) which are designed and disposed by the same method as the standard cell 20A, and the dummy patterns may have substantially the same shape and/or pattern density as those of the equivalent patterns of the integrated circuit of the standard cell 20A. The filler cell 20B of FIG. 12 may be a dummy source/drain region. The filler cell 20B may use various structures within a range of a cell which is used for filling a space secured in an integrated circuit, for spacing between standard cells.

A boundary between the filler cell 20B and the standard cell 20A may be formed through the single diffusion break SDB. The standard cell 20A and the filler cell 20B adjacent to each other may share the single diffusion break SDB at a common boundary therebetween. Accordingly, a single diffusion break SDB may be located at each of opposite boundaries of the filler cell 20B.

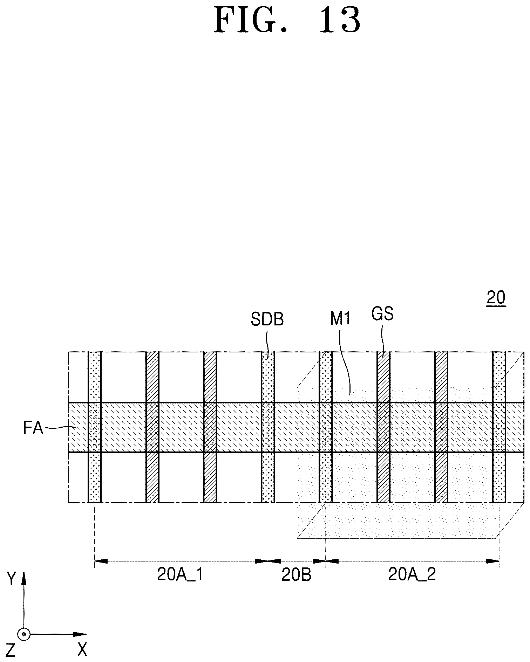

FIGS. 13 to 15 are diagrams for describing a mask used for controlling a threshold voltage of the integrated circuit 20 illustrated in FIG. 11. FIGS. 13 to 15 are diagrams for describing a mask used for controlling a threshold voltage, and in addition to the mask illustrated in FIGS. 13 to 15, a mask based on various shapes and combinations may be adopted within the technical scope of the inventive concept.

Referring to FIGS. 13 to 15, a first mask M1 may include an opening which opens (e.g., exposes) a first standard cell 20A_1 and a filler cell 20B (e.g., a dummy cell) and closes (e.g., covers) a second standard cell 20A_2 of a device under manufacture, and each of a second mask M2 and a third mask M3 may include an opening which opens (e.g., exposes) the filler cell 20B and closes (e.g., covers) the first standard cell 20A_1 and the second standard cell 20B_2 of a device under manufacture.

To control a threshold voltage (e.g., a first threshold voltage) of a first standard cell 20A_1, a first doping process in a state in which the first mask M1 is disposed, a second doping process in a state in which the second mask M2 is disposed, and a third doping process in a state in which the third mask M3 is disposed may be sequentially performed. Therefore, the first standard cell 20A_1 may have a first threshold voltage, and the filler cell 20B may have a second threshold voltage which differs from the first threshold voltage.

In some embodiments, a filler cell 20B having the structure illustrated in FIG. 12 may include a material having a dipole characteristic which differs from that of the first standard cell 20A_1. For example, the filler cell 20B may include a low work function dipole (LWD) formation material for reducing a work function, and the first standard cell 20A_1 may include a high work function dipole (HWD) formation material for increasing a work function.

In other embodiments, unlike the example illustrated in FIG. 12, the filler cell 20B may include a field effect transistor having a gate-all-around (GAA) structure including an active region in the form of a nanosheet and a gate surrounding the active region, similar to the first standard cell 20A_1 or the second standard cell 20A_2. For example, the filler cell 20B may include a structure in which a source/drain region 130 interposed between the plurality of single diffusion break SDB is connected to a gate structure GS.

The filler cell 20B may include a material which differs from that of the first standard cell 20A_1, or may have a different amount of dopants between the same materials, or may have a threshold voltage which differs from that of the first standard cell 20A_1. In other words, the filler cell 20B may differ from the first standard cell 20A_1 in any combination of these three characteristics (material, dopant amount, and threshold voltage). Accordingly, the filler cell 20B may be exposed in an opening of a mask M used in a doping process for controlling a threshold voltage of a first standard cell 20A_1. The filler cell 20B may be included in the semiconductor device, and may be processed according to the above doping process using the above-described masks, to affect the deposition and/or operation of other operational components of the semiconductor device.

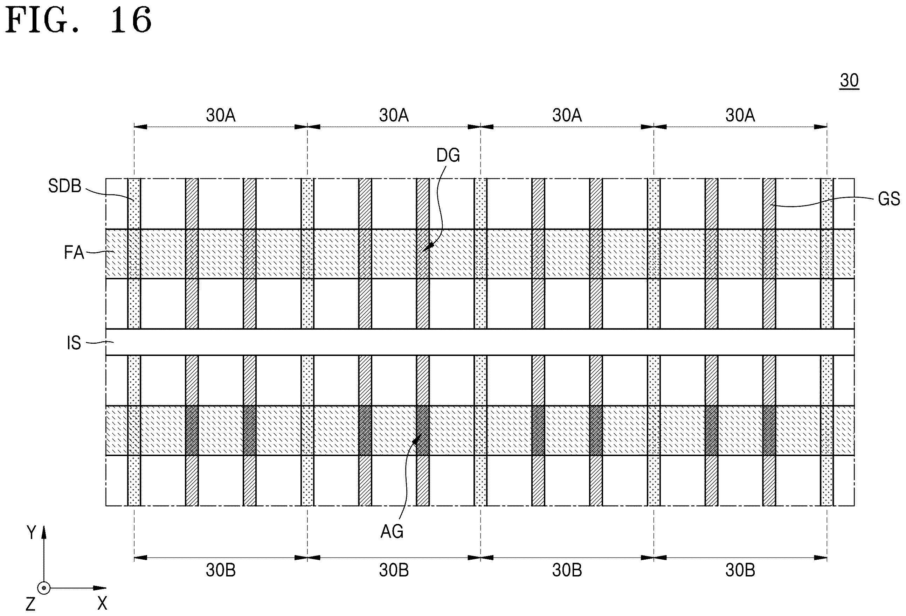

FIG. 16 is a diagram for describing an integrated circuit 30 according to other embodiments.

The integrated circuit 30 may be configured to be similar to the integrated circuit 10 described above with reference to FIGS. 3, 4A, and 4B, and thus, a difference therebetween will be mainly described below.

Referring to FIG. 16, the integrated circuit 30 may include a plurality of finishing cells 30A and a plurality of standard cells 30B which are surrounded by the plurality of finishing cells 30A in a second horizontal direction (a Y direction). For example, another set of finishing cells 30A may be formed below the plurality of standard cells 30B (e.g., in the -Y direction). In some embodiments, the plurality of finishing cells 30A may each include a dummy gate DG, and the plurality of standard cells 30B may each include an active gate AG.

The plurality of finishing cells 30A may be disposed outside the plurality of standard cells 30B in the second horizontal direction (the Y direction) and may have a structure which terminates a gate structure GS extending in the second horizontal direction (the Y direction).

A plurality of gate structures GS and a plurality of single diffusion breaks SDB may be apart from one another by about 1 CPP in a first horizontal direction (an X direction), and moreover, two gate structures GS may be arranged in the first horizontal direction (the X direction), and then, one single diffusion break SDB may be arranged. For example, two gate structures GS may be disposed between two adjacent single diffusion breaks SDB, and an interval between two adjacent single diffusion breaks SDB may be 3 CPP (e.g., about 3 CPP).

The integrated circuit 30 may include a cell isolation layer IS extending in the first horizontal direction (the X direction) along a boundary between the plurality of finishing cells 30A and the plurality of standard cells 30B. The cell isolation layer IS may include an insulating material and may fill a deep trench dividing an active region FA. The cell isolation layer IS may define the gate structure GS or the single diffusion break SDB at a boundary of a cell. The cell isolation layer IS may contact the gate structure GS and the single diffusion break SDB. The cell isolation layer IS may contact one end portion of the single diffusion break SDB and one end portion of the gate structure GS extending in the first horizontal direction (the X direction).

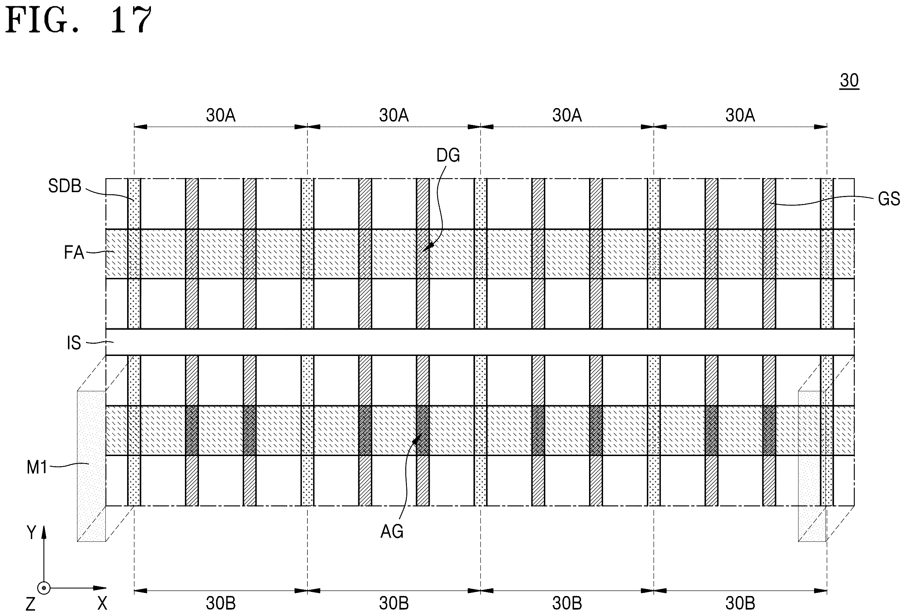

FIGS. 17 to 19 are diagrams for describing a mask used for controlling a threshold voltage of the integrated circuit 30 illustrated in FIG. 16. FIGS. 17 to 19 are diagrams for describing a mask used for controlling a threshold voltage, and in addition to the mask illustrated in FIGS. 17 to 19, a mask based on various shapes and combinations may be adopted within the technical scope of the inventive concept.

Referring to FIGS. 17 to 19, a first mask M1 may include an opening which opens (e.g., exposes) a plurality of finishing cells 30A and a plurality of standard cells 30B and closes (e.g., covers) the other region (e.g., a region other than the plurality of finishing cells and the plurality of standard cells, which may extend beyond the area illustrated in FIGS. 17 to 19), and each of a second mask M2 and a third mask M3 may include an opening which opens (e.g., exposes) the plurality of finishing cells 30A, closes (e.g., covers) the plurality of standard cells 30B, and again closes (e.g., covers) the other region.

To control a threshold voltage (e.g., a second threshold voltage) of the plurality of standard cells 30B, a first doping process in a state in which the first mask M1 is disposed, a second doping process in a state in which the second mask M2 is disposed, and a third doping process in a state in which the third mask M3 is disposed may be sequentially performed.

Therefore, the plurality of finishing cells 30A may have a first threshold voltage, and the plurality of standard cells 30B may have a second threshold voltage which differs from the first threshold voltage. The plurality of finishing cells 30A may include a material having a dipole characteristic or the amounts of dopants, which differs from that of the plurality of standard cells 30B.

The plurality of finishing cells 30A may have or include a threshold voltage which differs from that of the plurality of standard cells 30B, or may include a material which differs from that of the plurality of standard cells 30B, and thus, the plurality of finishing cells 30A may be exposed in an opening of a mask used in a doping process for controlling a threshold voltage of a standard cell.

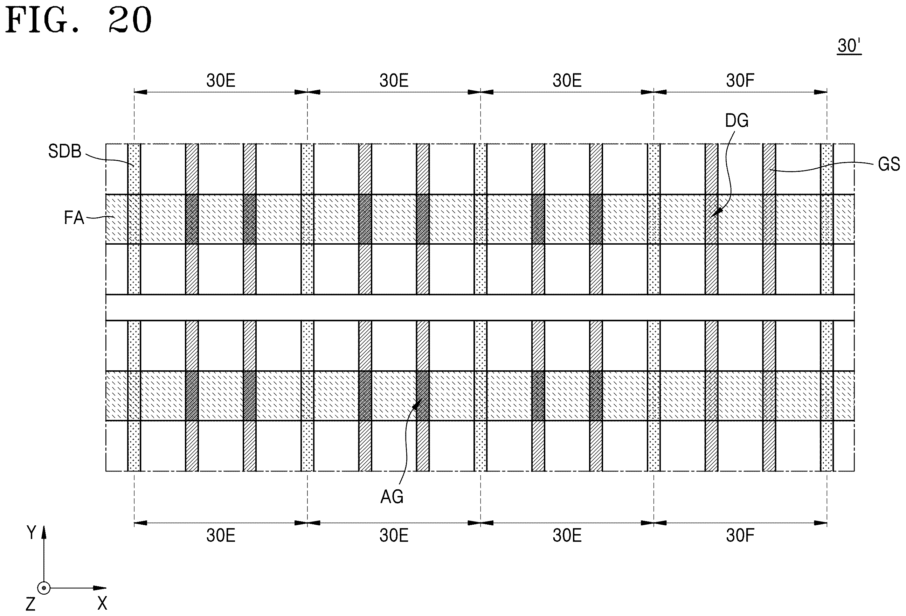

FIG. 20 is a diagram for describing an integrated circuit 30' according to other embodiments.

The integrated circuit 30' may be configured to be similar to the integrated circuit 30 described above with reference to FIG. 16, and thus, a difference therebetween will be mainly described below.

Referring to FIG. 20, the integrated circuit 30' may include a plurality of standard cells 30E and a plurality of finishing cells 30F which surround the plurality of standard cells 30E in a first horizontal direction (an X direction). In some embodiments, the plurality of standard cells 30E may each include an active gate AG, and the plurality of finishing cells 30F may each include a dummy gate DG.

The plurality of finishing cells 30F may be disposed outside the plurality of standard cells 30E in the first horizontal direction (the X direction) and may have a structure which terminates an active region FA extending in the first horizontal direction (the X direction).

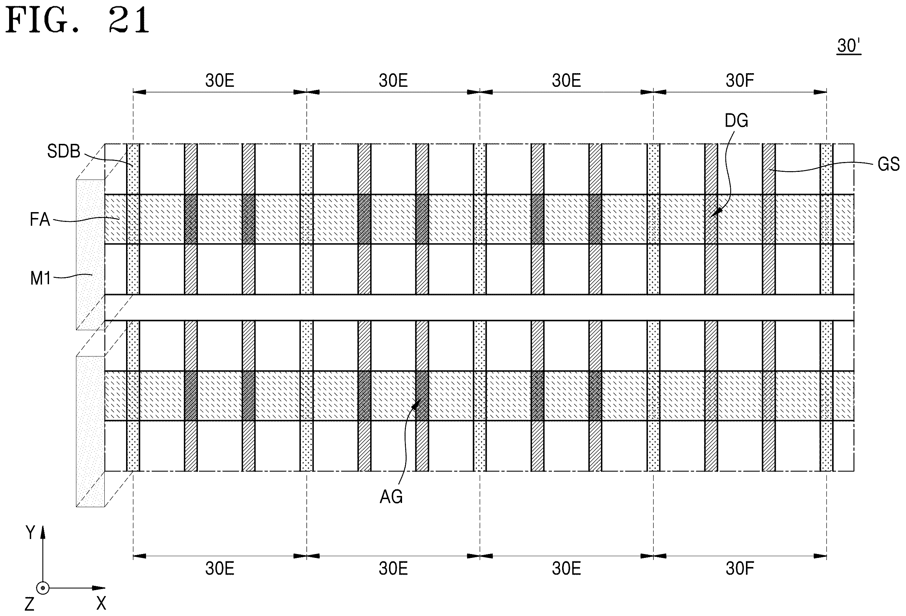

FIGS. 21 to 23 are diagrams for describing a mask used for controlling a threshold voltage of the integrated circuit illustrated in FIG. 20. In addition to the mask illustrated in FIGS. 21 to 23, a mask based on various shapes and combinations may be adopted within the technical scope of the inventive concept.

Referring to FIGS. 21 to 23, a first mask M1 may include an opening which opens (e.g., exposes) a plurality of standard cells 30E and a plurality of finishing cells 30F and closes (e.g., covers) the other region, and each of a second mask M2 and a third mask M3 may include an opening which opens (e.g., exposes) the plurality of finishing cells 30F and closes (e.g., covers) the plurality of standard cells 30E.

To control a threshold voltage (e.g., a second threshold voltage) of the plurality of standard cells 30E, a first doping process in a state in which the first mask M1 is disposed, a second doping process in a state in which the second mask M2 is disposed, and a third doping process in a state in which the third mask M3 is disposed may be sequentially performed.

Therefore, the plurality of finishing cells 30F may have a first threshold voltage, and the plurality of standard cells 30E may have a second threshold voltage which differs from the first threshold voltage. The plurality of finishing cells 30F may include a material having a dipole characteristic or the amounts of dopants, which differs from that of the plurality of standard cells 30E.

The plurality of finishing cells 30F may have or include a threshold voltage which differs from that of the plurality of standard cells 30E, or may include a material which differs from that of the plurality of standard cells 30B, and thus, the plurality of finishing cells 30F may be exposed in an opening of a mask used in a doping process for controlling a threshold voltage of a standard cell.

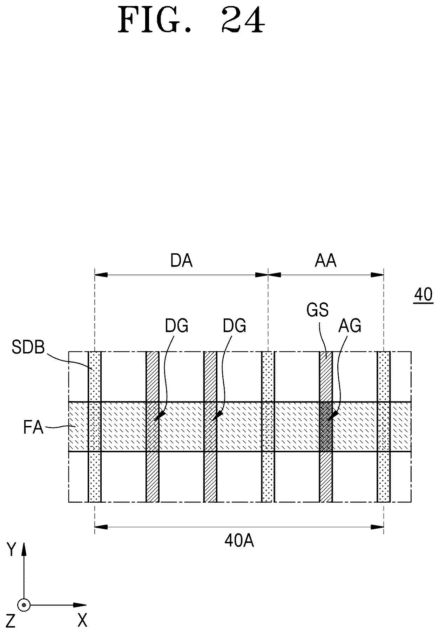

FIG. 24 is a diagram for describing an integrated circuit 40 according to other embodiments.

The integrated circuit 40 may be configured to be similar to the integrated circuit 10 described above with reference to FIGS. 3, 4A, and 4B, and thus, a difference therebetween will be mainly described below.

Referring to FIG. 24, the integrated circuit 40 may include a switch cell 40A. The switch cell 40A may include a plurality of gate structures GS and a single diffusion break SDB disposed between the plurality of gate structures GS. Some of the plurality of gate structures GS may form an active gate AG which is activated to electrically configure a transistor, and the other gate structures GS may form a dummy gate DG which does not electrically configure a transistor. The switch cell 40A may include at least one dummy gate DG and at least one active gate AG. The dummy gate DG may be defined as an electrically deactivated gate.

With respect to a first side surface and a second side surface of the dummy gate DG opposite to each other in a first horizontal direction (an X direction), a region within a range of about 1 CPP from the first side surface and a region within a range of about 1 CPP from the second side surface may be defined as a dummy gate region DA. As illustrated in FIG. 24, with respect to a first side surface and a second side surface of each of a plurality of dummy gates DG, a region within a range of about 1 CPP from the first side surface and a region within a range of about 1 CPP from the second side surface may be defined as the dummy gate region DA, and thus, a region between two single diffusion breaks SDB apart from each other with one or more (e.g. a plurality of) dummy gates DG therebetween may be defined as the dummy gate region DA. Also, with respect to a first side surface and a second side surface of an active gate AG opposite to each other in the first horizontal direction (the X direction), a region within a range of about 1 CPP from the first side surface and a region within a range of about 1 CPP from the second side surface may be defined as an active gate region AA. As illustrated in FIG. 24, with respect to the first side surface and the second side surface of the active gate AG, a region within a range of about 1 CPP from the first side surface and a region within a range of about 1 CPP from the second side surface may be defined as the active gate region AA, and thus, a region between two single diffusion breaks SDB apart from each other with one or more (e.g. a plurality of) active gates AG therebetween may be defined as the active gate region AA.

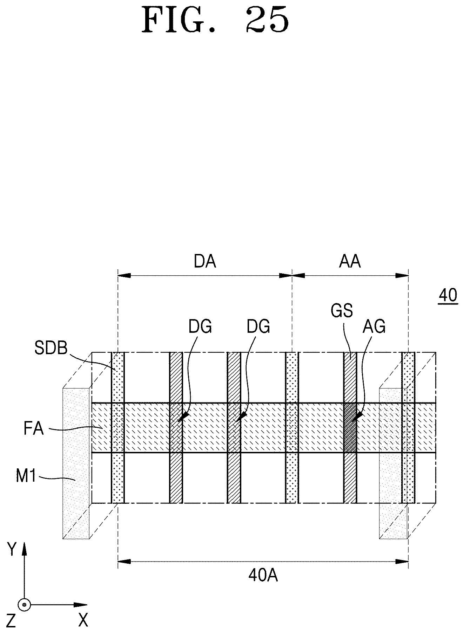

FIGS. 25 to 27 are diagrams for describing a mask used for controlling a threshold voltage of the integrated circuit illustrated 40 in FIG. 24. FIGS. 25 to 27 are diagrams for describing a mask used for controlling a threshold voltage, and in addition to the mask illustrated in FIGS. 25 to 27, a mask based on various shapes and combinations may be adopted within the technical scope of the inventive concept.

Referring to FIGS. 25 to 27, a first mask M1 may include an opening which opens (e.g., exposes) a dummy gate region DA and an active gate region AA and closes (e.g., covers) the other region, and each of a second mask M2 and a third mask M3 may include an opening which opens (e.g., exposes) the dummy gate region DA and closes (e.g., covers) the active gate region AA.

To control a threshold voltage (e.g., a second threshold voltage) of the active gate region AA, a first doping process in a state in which the first mask M1 is disposed, a second doping process in a state in which the second mask M2 is disposed, and a third doping process in a state in which the third mask M3 is disposed may be sequentially performed. Therefore, the dummy gate region DA may have a first threshold voltage, and the active gate region AA may have a second threshold voltage which differs from the first threshold voltage. In other words, the dummy gate region DA may include a material having a dipole characteristic which differs from that of the active gate region AA.

The dummy gate region DA may have a threshold voltage which differs from that of the active gate region AA, or may include a material which differs from that of the active gate region AA, or may have different amounts of dopants between the same materials (e.g., the dummy gate region DA may have a different doping amount to the active gate region AA), and thus, the dummy gate region DA may be exposed in an opening of a mask used in a doping process for controlling a threshold voltage of a standard cell.

Embodiments are set out in the following Clauses:

Clause 1. A mask comprising:

a plurality of logic cell regions corresponding to a location where a plurality of respective logic cells of a semiconductor device to be manufactured are to be positioned; and
switch cell regions, each disposed between adjacent logic cell regions of the plurality of logic cell regions, or the switch cell regions disposed to surround at least a first logic cell region of the plurality of logic cell regions,
wherein each switch cell region corresponds to a location of the semiconductor device to be manufactured that is electrically isolated from each of the plurality of logic cells, and
wherein the mask comprises, when placed in a position above the semiconductor device to be manufactured, a first opening corresponding to a logic cell region selected from among the plurality of logic cell regions and a second opening in a first switch cell region of the switch cell regions.

Clause 2. The mask of Clause 1, wherein

each switch cell region is disposed between two adjacent logic cell regions of the plurality of logic cell regions, and
the semiconductor device to be manufactured includes a portion corresponding to the switch cell region and comprising:

a first single diffusion break and a second single diffusion break apart from each other in a first horizontal direction; and
a signal tap cell including a backside through via passing through a region between the first single diffusion break and the second single diffusion break, and
the second opening exposes the signal tap cell.

Clause 3. The mask of Clause 1, wherein:

each switch cell region is disposed between two adjacent logic cell regions of the plurality of logic cell regions,
the semiconductor device to be manufactured includes a portion corresponding to the switch cell region and comprising a filler cell including a first single diffusion break and a second single diffusion break apart from each other by a distance of 1 contacted poly pitch (CPP) in a first horizontal direction, and
the second opening exposes the filler cell.

Clause 4. An integrated circuit comprising:

a plurality of logic cell regions where a plurality of respective logic cells are formed;
a first switch cell region disposed adjacent to a first logic cell region of the plurality of logic cell regions;
a plurality of power rails extending in a first horizontal direction, formed in the plurality of logic cell regions and the first switch cell region, and configured to be supplied with a source voltage;
a plurality of first gate structures disposed apart from each other in the first horizontal direction in one logic cell region selected from among the plurality of logic cell regions and extending in a second horizontal direction intersecting with the first horizontal direction; and
a plurality of second gate structures disposed apart from each other in the first horizontal direction in the switch cell region and extending in the second horizontal direction,
wherein the switch cell region electrically isolated from each of the plurality of logic cell regions, and
the plurality of first gate structures and the plurality of second gate structures result in transistors controlled by the first gate structures having different threshold voltages from transistors controlled by the second gate structures.

Clause 5. The integrated circuit of Clause 4, wherein:

the first switch cell region is disposed between two logic cell regions of the plurality of logic cell regions, and
the switch cell region comprises:

a first single diffusion break and a second single diffusion break apart from each other in a first horizontal direction;
a signal tap cell including a backside through via passing through a region between the first single diffusion break and the second single diffusion break; and
an adjacent cell adjacent to the signal tap cell in the first horizontal direction, and
the adjacent cell comprises the plurality of second gate structures.

Clause 6. The integrated circuit of Clause 4, wherein:

the first switch cell region is disposed between two logic cell regions of the plurality of logic cell regions,
the first switch cell region comprises a filler cell including a first single diffusion break and a second single diffusion break apart from each other by a distance of 1 contacted poly pitch (CPP) in the first horizontal direction, and
the filler cell comprises the plurality of second gate structures.

Clause 7. The integrated circuit of any of Clauses 4-6, wherein the first switch cell region is one of a plurality of switch cell regions that together surround the plurality of logic cell regions,

the plurality of switch cell regions comprise a first finishing cell having a structure terminating a plurality of first gate structures arranged apart from one another in the first horizontal direction and extending in the second horizontal direction, in the plurality of logic cell regions, and
the first finishing cell comprises the plurality of second gate structures.

Clause 8. The integrated circuit of any of Clauses 4-7, wherein the first switch cell region is one of a plurality of switch cell regions that together surround the plurality of logic cell regions,

the plurality of switch cell regions comprise a first finishing cell having a structure terminating the plurality of active regions extending in the first horizontal direction in the plurality of logic cell regions, and
the first finishing cell comprises the plurality of second gate structures.

Clause 9. The integrated circuit of any of Clauses 4-8, wherein the plurality of second gate structures in the switch cell region comprise:

an active gate electrically configuring a transistor; and

a dummy gate which does not electrically configure a transistor, and

the dummy gate and the active gate have different threshold voltages.

Clause 10. A method of controlling threshold voltages for a plurality of transistors of a device to be manufactured, the device to be manufactured including a plurality of logic cell regions in which a logic cell is formed, an active cell region in which an active cell is formed, and a first dummy cell region adjacent to a first logic cell region of the plurality of logic cell regions and adjacent to the active cell region, the first dummy cell region including a break region electrically isolated from each of the plurality of logic cell regions, the logic cell having a first width in a first direction and the active cell having a second width smaller than the first width in the first direction, the first dummy cell region being adjacent to the active cell region in the first direction, the method including:

placing a device under manufacture that is to be formed into the device to be manufactured in a process chamber, the device under manufacture having device regions that correspond to the regions of the device to be manufactured;

performing a first doping process on the device under manufacture by using a first mask that includes an opening exposing the device region corresponding to the active cell, exposing the device region corresponding to the first dummy cell region, and exposing the device region corresponding to the first logic cell region; and

performing a second doping process on the device under manufacture by using a second mask that includes an opening exposing the device region corresponding to the active cell, exposing the device region corresponding to the first dummy cell region, and covering the device region corresponding to the first logic cell region.

Clause 11. The method of Clause 10, wherein:
a combined width of the active cell region and the adjacent dummy cell region in the first direction is smaller than a width of the first logic cell region in the first direction.

Clause 12. The method of Clause 10 or Clause 11, wherein:
the dummy cell region is a switch cell region.

Clause 13. The method of any of Clauses 10-12, wherein:

the first logic cell region, the dummy cell region, and the active cell region are arranged along the first direction;

throughout a combined region including the first logic cell region, the dummy cell region, and the active cell region, a plurality of line patterns are formed to extend in a second direction perpendicular to the first direction, and are spaced apart from each other according to a constant pitch in the first direction; and

the width in the first direction of the active cell region is equal to or smaller than two times the pitch.

Clause 14. The method of any of Clauses 10-13, wherein:
as a result of the first and second doping processes with the different masks, a threshold voltage of a transistor in the active cell region is different from a threshold voltage of a transistor in the first logic cell region.

Clause 15. The method of any of Clauses 10-14, wherein the active cell includes an operational transistor, and the dummy cell does not include an operational transistor.

Hereinabove, exemplary embodiments have been described in the drawings and the specification. Embodiments have been described by using the terms described herein, but this has been merely used for describing the inventive concept and has not been used for limiting a meaning or limiting the scope of the inventive concept defined in the following claims. Therefore, it may be understood by those of ordinary skill in the art that various modifications and other equivalent embodiments may be implemented from the inventive concept. Accordingly, the scope of the invention may be defined based on the scope of the following claims.
While the inventive concept has been particularly shown and described with reference to embodiments thereof, it will be understood that various changes in form and details may be made therein without departing from the scope of the following claims.

**Claims**

1. A mask comprising:

a plurality of logic cell regions (3) corresponding to a location where a plurality of respective logic cells of a semiconductor device (1) to be manufactured are to be positioned; and

switch cell regions (5), wherein each switch cell region (5) is disposed between adjacent logic cell regions of the plurality of logic cell regions (3), or wherein the switch cell regions (5) are disposed to surround at least a first logic cell region of the plurality of logic cell regions (3), wherein each switch cell region (5) corresponds to a location of the semiconductor device (1) to be manufactured that is electrically isolated from each of the plurality of respective logic cells (3), and

wherein the mask comprises, when placed in a position above the semiconductor device (1) to be manufactured, a first opening (OP1) corresponding to a logic cell region selected from among the plurality of logic cell regions (3) and a second opening (OP2) in a first switch cell region of the switch cell regions (5).

2. The mask of claim 1, wherein

each switch cell region (5) is disposed between two adjacent logic cell regions of the plurality of logic cell regions (3), and

the semiconductor device (1) to be manufactured includes, for each switch cell region (5), a portion corresponding to the switch cell region (5) and comprising:

a first single diffusion break (SDB) and a second single diffusion break (SDB) apart from each other in a first horizontal direction; and

a signal tap cell (STC) including a backside through via (BTV) passing through a region between the first single diffusion break (SDB) and the second single diffusion break (SDB), and

the second opening (OP2) exposes the signal tap cell (STC).

3. The mask of claim 1, wherein:

each switch cell region (5) is disposed between two adjacent logic cell regions of the plurality of logic cell regions (3),

the semiconductor device (1) to be manufactured includes, for each switch cell region (5), a portion corresponding to the switch cell region (5) and comprising a filler cell (20B) including a first single diffusion break (SDB) and a second single diffusion break (SDB) apart from each other by a distance of one contacted poly pitch in a first horizontal direction, and

the second opening exposes (OP2) the filler cell (20B).

4. An integrated circuit comprising:

a plurality of logic cell regions (3) where a plurality of respective logic cells are formed;

a first switch cell region (5) disposed adjacent to a first logic cell region of the plurality of logic cell regions (3);

a plurality of power rails (PR1, PR2) extending in a first horizontal direction, formed in the plurality of logic cell regions (3) and the first switch cell region (5), and configured to be supplied with a source voltage;

a plurality of first gate structures (GS) disposed apart from each other in the first horizontal direction in one logic cell region selected from among the plurality of logic cell regions (3) and extending in a second horizontal direction intersecting with the first horizontal direction; and

a plurality of second gate structures (GS) disposed apart from each other in the first horizontal direction in the first switch cell region (5) and extending in the second horizontal direction,

wherein the first switch cell region (5) is electrically isolated from each of the plurality of logic cell regions (3), and

the plurality of first gate structures (GS) and the plurality of second gate structures (GS) result in transistors controlled by the first gate structures having different threshold voltages from transistors controlled by the second gate structures.

5. The integrated circuit of claim 4, wherein:

the first switch cell region (5) is disposed between two logic cell regions of the plurality of logic cell regions (3), and

the first switch cell region (5) comprises:

a first single diffusion break (SDB) and a second single diffusion break (SDB) apart from each other in a first horizontal direction;

a signal tap cell (STC) including a backside through via (BTV) passing through a region between the first single diffusion break (SDB) and the second single diffusion break (SDB); and

an adjacent cell (10A) adjacent to the signal tap cell (STC) in the first horizontal direction, and

the adjacent cell (10A) comprises the plurality of second gate structures (GS).

6. The integrated circuit of claim 4, wherein:

the first switch cell region (5) is disposed between two logic cell regions of the plurality of logic cell regions (3),

the first switch cell region (5) comprises a filler cell (20B) including a first single diffusion break (SDB) and a second single diffusion break (SDB) apart from each other by a distance of one contacted poly pitch in the first horizontal direction, and

the filler cell (20B) comprises the plurality of second gate structures (GS).

7. The integrated circuit of any of claims 4-6, wherein the first switch cell region (5) is one of a plurality of switch cell regions (5) that together surround the plurality of logic cell regions (3),

the plurality of switch cell regions (5) comprise a first finishing cell (30A) having a structure terminating a plurality of first gate structures (GS) arranged apart from one another in the first horizontal direction and extending in the second horizontal direction, in the plurality of logic cell regions (3), and

the first finishing cell (30A) comprises the plurality of second gate structures (GS).

8. The integrated circuit of any of claims 4-7, wherein the first switch cell region (5) is one of a plurality of switch cell regions (5) that together surround the plurality of logic cell regions (3),

the plurality of switch cell regions (5) comprise a first finishing cell (30F) having a structure terminating the plurality of active regions (FA) extending in the first horizontal direction in the plurality of logic cell regions (3), and

the first finishing cell (30F) comprises the plurality of second gate structures (GS).

9. The integrated circuit of any of claims 4-8, wherein the plurality of second gate structures (GS) in the first switch cell region (5) comprise:

an active gate (AG) electrically configuring a transistor; and

a dummy gate (DG) which does not electrically configure a transistor, and

the dummy gate (DG) and the active gate (AG) have different threshold voltages.

10. A method of controlling threshold voltages for a plurality of transistors of a device to be manufactured, the device to be manufactured including a plurality of logic cell regions (3) in which a logic cell is formed, an active cell region (10A) in which an active cell is formed, and a first dummy cell region (STC) adjacent to a first logic cell region (10B) of the plurality of logic cell regions (3) and adjacent to the active cell region (10A), the first dummy cell region (STC) including a break region electrically isolated from each of the plurality of logic cell regions (3), the logic cell having a first width in a first direction and the active cell having a second width smaller than the first width in the first direction, the first dummy cell region (STC) being adjacent to the active cell region (10A) in the first direction, the method including:

placing a device under manufacture that is to be formed into the device to be manufactured in a process chamber, the device under manufacture having device regions that correspond to the regions of the device to be manufactured; performing a first doping process on the device under manufacture by using a first mask (M1) that includes an opening exposing the device region corresponding to the active cell, exposing the device region corresponding to the first dummy cell region (STC), and exposing the device region corresponding to the first logic cell region (10B); and performing a second doping process on the device under manufacture by using a second mask (M2) that includes an opening exposing the device region corresponding to the active cell, exposing the device region corresponding to the first dummy cell region (STC), and covering the device region corresponding to the first logic cell region (10B).

11. The method of claim 10, wherein: a combined width of the active cell region (10A) and the adjacent first dummy cell region (STC) in the first direction is smaller than a width of the first logic cell region (10B) in the first direction.

12. The method of claim 10 or claim 11, wherein: the first dummy cell region (STC) is a switch cell region.

13. The method of any of claims 10-12, wherein:

the first logic cell region (10B), the first dummy cell region (STC), and the active cell region (10A) are arranged along the first direction; throughout a combined region including the first logic cell region (10B), the first dummy cell region (STC), and the active cell region (10A), a plurality of line patterns are formed to extend in a second direction perpendicular to the first direction, and are spaced apart from each other according to a constant pitch in the first direction; and

the width in the first direction of the active cell region (10A) is equal to or smaller than two times the pitch.

14. The method of any of claims 10-13, wherein: as a result of the first and second doping processes with the different masks, a threshold voltage of a transistor in the active cell region (10A) is different from a threshold voltage of a transistor in the first logic cell region (10B).

**15.** The method of any of claims 10-14, wherein the active cell includes an operational transistor, and a dummy cell within the dummy cell region (STC) does not include an operational transistor.

# FIG. 1

# FIG. 2

OP2　M　OP2　OP1　3　OP2　5　PR1　OP2　W1

Switch Cell | Logic Cell | Switch Cell | Logic Cell | Switch Cell | Logic Cell | Switch Cell

Switch Cell | Logic Cell | Switch Cell | Logic Cell | Switch Cell | Logic Cell | Switch Cell

W2　PR2

1

Y X

EP 4 761 512 A2

# FIG. 3

EP 4 761 512 A2

# FIG. 4A

# FIG. 4B

SDB     CAS     SDB     10

102

BTV

Z

Y   X

A2–A2

# FIG. 5

EP 4 761 512 A2

# FIG. 6

EP 4 761 512 A2

FIG. 7

EP 4 761 512 A2

# FIG. 8

EP 4 761 512 A2

10

SDB

130

GS

FA

M1

10B_1    STC    10A    10B_2

Y
Z    X

FIG. 9

EP 4 761 512 A2

# FIG. 10

EP 4 761 512 A2

# FIG. 11

# FIG. 12

# FIG. 13

# FIG. 14

# FIG. 15

FIG. 16

30

GS

30A 30A 30A 30A

30B 30B 30B 30B

DG

AG

SDB

FA

IS

X Y Z

# FIG. 17

EP 4 761 512 A2

# FIG. 18

EP 4 761 512 A2

FIG. 19

# FIG. 20

# FIG. 21

EP 4 761 512 A2

# FIG. 22

30'

30E   30E   30E   30F

DG

SDB

FA

M2

GS

AG

Y
Z   X

EP 4 761 512 A2

# FIG. 23

# FIG. 24

# FIG. 25

# FIG. 26

# FIG. 27